# EUROPEAN PATENT SPECIFICATION

(11) **EP 4 395 088 B1**
(45) Date of publication and mention of the grant of the patent: **02.12.2026**
(21) Application number: 22878276.9
(22) Date of filing: 08.09.2022
(51) Int. Cl.: H01S 5/11, H01S 5/042, H01S 5/185, H01S 5/343, H01S 5/00, H01S 5/20, H01S 5/30, H01S 5/32

(54) **SURFACE-EMITTING LASER ELEMENT**
OBERFLÄCHENEMITTIERENDES LASERELEMENT
ÉLÉMENT LASER À ÉMISSION DE SURFACE

(30) Priority: 05.10.2021 JP 2021164063
(43) Date of publication of application: 03.07.2024
(73) Proprietor: Kyoto University, Kyoto-shi, Kyoto 606-8501 (JP); Stanley Electric Co., Ltd., Meguro-ku Tokyo 153-8636 (JP)
(72) Inventor: NODA, Susumu, Kyoto-shi, Kyoto 606-8501 (JP); INOUE, Takuya, Kyoto-shi, Kyoto 606-8501 (JP); KOIZUMI, Tomoaki, Tokyo 153-8636 (JP); EMOTO, Kei, Tokyo 153-8636 (JP)
(74) Representative: Wimmer, Hubert
(86) International application number: PCT/JP2022/033799
(87) International publication number: WO 2023/058405

(56) References cited:
- WO-A1-2014/175447
- WO-A1-2021/186965
- JP-A- 2010 283 335
- JP-A- 2013 128 150
- US-A1- 2009 279 579
- US-A1- 2012 170 109
- US-A1- 2021 226 420
- US-A1- 2021 273 411
- YOSHIDA M ET AL: "Elliptical double-hole photonic-crystal surface-emitting lasers", 2017 CONFERENCE ON LASERS AND ELECTRO-OPTICS PACIFIC RIM (CLEO-PR), IEEE, 31 July 2017 (2017-07-31), pages 1 - 3, XP033260652, DOI: 10.1109/CLEOPR.2017.8118793
- DE ZOYSA MENAKA ET AL: "Light Detection Functionality of Photonic-Crystal Lasers", IEEE JOURNAL OF QUANTUM ELECTRONICS, IEEE, USA, vol. 57, no. 4, 21 June 2021 (2021-06-21), pages 1 - 8, XP011865093, ISSN: 0018-9197, [retrieved on 20210702], DOI: 10.1109/JQE.2021.3091153

## Description

### Technical Field

The present invention relates to a surface-emitting laser element, and particularly to a surface-emitting laser element having a photonic crystal.

### Background Art

In recent years, the development of a photonic-crystal surface-emitting laser using a photonic crystal (PC) has progressed.

For example, WO 2018/155710 A1 discloses a photonic-crystal surface-emitting laser having a photonic crystal of a single lattice and having a high diffraction effect.

In addition, JP 2020-045573 A discloses that a photonic-crystal surface-emitting laser that has a multi-lattice photonic crystal layer, has a high flatness and crystallinity of an active layer, has high light extraction efficiency, and can perform an oscillation operation with a low threshold value current density and high quantum efficiency.

US 2021/226420 A1 relates to a surface emitting type light-emitting element mainly including a nitride semiconductor and a layer for forming a resonance mode. The light-emitting element increases the optical confinement coefficient of a layer forming a resonance mode, includes an active layer, a phase modulation layer, and one or more high refractive index layers, and further includes, first and second cladding layers sandwiching the active layer, the phase modulation layer, and the high refractive index layer. The phase modulation layer includes a base layer and modified refractive index regions. The gravity centers of the modified refractive index regions are arranged on a straight line passing through each lattice point of a virtual square lattice and tilted with respect to the square lattice. The distance between the gravity center of each modified refractive index region and the lattice point is individually set according to the optical image.

US 2021/273411 A1 relates to a light-emitting device comprising a reflective metasurface modulating a phase for each of pixels constituting a one- or two-dimensional array. The light-emitting device comprises a surface emitting laser element, a light guide layer, and the metasurface. The metasurface has a light transmissive layer including a dielectric layer, one metal film on one surface thereof, and the other metal film on the other surface thereof. In each of unit regions corresponding to the pixels, the light transmissive layer includes a portion exposed without being covered with the metal film. The width of each unit region and the thickness of the light transmissive layer are smaller than the wavelength of the laser light input to the metasurface. The metasurface modulates the phase of the laser light for each unit region. A first light output surface outputs the modulated laser.

WO 2021/186965 A1 discloses a first guide layer including a photonic-crystal layer that is formed on a c surface of a group III nitride semiconductor and that has holes which are arranged with two-dimensional periodicity in a plane parallel to the layer, and an embedded layer that is formed on the photonic-crystal layer and that closes the holes; an active layer that is formed on the first guide layer; and a second guide layer that is formed on the active layer. A hole set, which includes at least a main hole and a sub hole that is smaller in size than the main hole, is disposed at each square lattice point in the plane parallel to the photonic-crystal layer. The main holes have a regular hexagonal prism shape, an elongated hexagonal prism shape, or an elliptical prism shape in which the longer axis is parallel to a <11-20> axis.

WO 2014/175447 A1 discloses a semiconductor laser device with a semiconductor laser chip and a spatial light modulator (SLM) which is optically coupled to said semiconductor laser chip. The semiconductor laser chip (LDC) is provided with an active layer, a pair of cladding layers sandwiching the active layer, and a diffractive grating layer which is optically coupled to the active layer. The spatial light modulator (SLM) is provided with a transparent common electrode, multiple transparent pixel electrodes, and a liquid crystal layer (LC) arranged between the common electrode and the pixel electrodes. Laser light outputted along the thickness direction of the diffractive grating layer is modulated by means of the spatial light modulator (SLM) and is transmitted through the same to be outputted externally.
Non-Patent Document 1: Y. Liang et al.: Phys. Rev. B vol.84, 195119 (2011)

### Summary of Invention

### Technical Problem

However, there is a demand for higher performance of a photonic-crystal surface-emitting laser such as those having higher emission efficiency and operating with a low threshold value current density and high quantum efficiency.

The inventor of the present application has paid attention to a diffraction surface (wave source position) in a photonic crystal, and has found that a photonic-crystal surface-emitting laser having high emission efficiency and high performance can be realized by specifying an interference condition between diffracted light and the reflected diffracted light by a reflection mirror.

The invention of the present application has been made based on such a finding, and an object of the present application is to provide a high-output photonic-crystal surface-emitting laser having high emission efficiency and operating with a low threshold value current density.

### Solution to Problem

A surface-emitting laser element according to the present invention is provided as set forth in claim 1. Preferred embodiments of the present invention may be gathered from the dependent claims.

### Brief Description of Drawings

FIG. 1A is a cross-sectional view schematically illustrating an example of a structure of a PCSEL element 10 according to a first embodiment of the present invention.
FIG. 1B is a partially enlarged cross-sectional view schematically illustrating an air-hole layer 14P (photonic crystal layer) of FIG. 1A and air holes 14K arranged in the air-hole layer 14P.
FIG. 2A is a plan view schematically illustrating an upper surface of the PCSEL element 10.
FIG. 2B is a cross-sectional view schematically illustrating a cross section of the air-hole layer 14P in a plane parallel to an n-side guide layer 14.
FIG. 2C is a plan view schematically illustrating a bottom surface of the PCSEL element 10.
FIG. 3 is a plan view schematically illustrating a main opening K1 and a secondary opening K2 of a resist, and holes 14H1 and 14H2 after etching.
FIG. 4 is a cross-sectional view schematically illustrating a cross section of the air-hole layer 14P, which is perpendicular to the crystal layer.
FIG. 5 is a cross-sectional SEM image of the air hole 14K of the first embodiment.
FIG. 6A is a cross-sectional view schematically illustrating an example of a structure of a PCSEL element 30 according to a second embodiment.
FIG. 6B is an enlarged cross-sectional view schematically illustrating the air-hole layer 14P of FIG. 6A and an air hole pair 14K arranged in the air-hole layer 14P.
FIG. 6C is a cross-sectional view schematically illustrating a cross section of the air-hole layer 14P in a plane parallel to the air-hole layer 14P.
FIG. 7A is an upper surface SEM image illustrating air hole shapes of a main air hole 14K1 and a secondary air hole 14K2.
FIG. 7B is an SEM image illustrating a cross section of FIG. 7A along a line A-A.
FIG. 8 is a diagram illustrating a photonic band structure of the air-hole layer, which is the photonic crystal layer.
FIG. 9 is a diagram illustrating a slope efficiency ηSE with respect to αn/αp.
FIG. 10 is a diagram illustrating dependence of the slope efficiency ηSE with respect to a phase difference θ when a slope efficiency in a case of no reflection is used for standardization.
FIG. 11 is a diagram illustrating an electric field amplitude of a radiated wave when light propagating in the air-hole layer 14P in an x-axis direction is diffracted by the air hole and radiated in a vertical direction in a single lattice structure.
FIG. 12A is a diagram illustrating a position of a diffraction surface WS with respect to a thickness of the air-hole layer 14P.
FIG. 12B is a diagram illustrating a position of the diffraction surface WS with respect to an air hole filling ratio FF.
FIG. 12C is a diagram illustrating a position of the diffraction surface WS with respect to a thickness d_{EMB} of an embedded layer 14B.
FIG. 13 is a cross-sectional view schematically illustrating disposition of the main air hole 14K1 and the secondary air hole 14K2 in a depth direction.
FIG. 14A is a diagram illustrating an electric field amplitude of a radiated wave when light propagating in the air-hole layer 14P in the x-axis direction is diffracted by the air hole and radiated in a vertical direction in a multi-lattice structure.
FIG. 14B is a diagram illustrating an electric field distribution of light propagating in the air-hole layer 14P in an xy-plane around the main air hole 14K1 and the secondary air hole 14K2.
FIG. 15A is a diagram illustrating a result of calculating the possible slope efficiency ηSE with respect to the phase difference θ (deg) between a direct diffracted light Ld and a reflected diffracted light Lr on the diffraction surface WS in the first embodiment.
FIG. 15B is a diagram illustrating a calculation result of the phase difference θ with respect to a wavelength λ in the first embodiment.
FIG. 15C is a diagram illustrating a calculation result of the phase difference θ with respect to an air hole period PC in the first embodiment.
FIG. 16 is a diagram in which the slope efficiency ηSE obtained by an experiment is plotted (marked as a circle) with respect to the phase difference θ in the first embodiment.
FIG. 17A is a diagram illustrating a result of calculating the possible slope efficiency ηSE with respect to the phase difference θ (deg) in a second embodiment.
FIG. 17B is a diagram illustrating a calculation result of the phase difference θ with respect to the wavelength λ in the second embodiment.
FIG. 17C is a diagram illustrating a calculation result of the phase difference θ with respect to the air hole period PC in the second embodiment.
FIG. 18 is a diagram in which the slope efficiency ηSE obtained by an experiment is plotted (marked as a circle) with respect to the phase difference θ in the second embodiment.
FIG. 19 is a diagram illustrating dependence of the slope efficiency ηSE with respect to the phase difference θ when only interference between the direct diffracted light Ld and the reflected diffracted light Lr is considered (single-dot chain line and broken line) and when an influence of the interference on a radiation loss αn is taken into consideration (thick solid line and thin solid line).
FIG. 20A is a diagram illustrating a position of the diffraction surface WS with respect to a difference h_{DOWN} of lower ends of the main air hole 14K1 and the secondary air hole 14K2 when a difference h_{UP} of upper ends of the main air hole 14K1 and the secondary air hole 14K2 is constant.
FIG. 20B is a diagram illustrating a position of the diffraction surface WS with respect to the difference h_{DOWN} of the lower ends of the main air hole 14K1 and the secondary air hole 14K2 when a depth h_{K2} of the secondary air hole 14K2 is constant.
FIG. 20C is a diagram illustrating a position of the diffraction surface WS with respect to the difference h_{DOWN} of the lower ends of the main air hole 14K1 and the secondary air hole 14K2 when the depth h_{K2} of the secondary air hole 14K2 is constant.
FIG. 20D is diagram illustrating a position of the diffraction surface WS when centroid in-between distances Δx and Δy of the main air hole 14K1 and the secondary air hole 14K2 in x-axis and y-axis directions are changed from 0.25 PC to 0.5 PC by setting Δx = Δy.

### Description of Embodiments

Hereinafter, preferred embodiments of the present invention will be described. In addition, in the following description and the accompanying drawings, substantially the same or equivalent parts will be described with the same reference numerals.

### [First Embodiment]

### 1. Structure of Photonic-Crystal Surface-Emitting Laser

A photonic-crystal surface-emitting laser (hereinafter, also referred to as a PCSEL) has a resonator layer in a direction parallel to a semiconductor light emission structure layer (an n-side guide layer, a light emission layer, and a p-side guide layer) constituting a light emission element, and is an element that radiates coherent light in a direction orthogonal to the resonator layer.

On the other hand, a distributed bragg reflector (DBR) laser having a pair of resonator mirrors (Bragg reflectors) that interpose a semiconductor light emission structure layer is known, but a photonic-crystal surface-emitting laser (PCSEL) differs from the DBR laser in the following points. That is, in the photonic-crystal surface-emitting laser (PCSEL), a light wave propagating in a plane parallel to the photonic crystal layer is diffracted due to the diffraction effect of the photonic crystal to form a two-dimensional resonance mode and is also diffracted in a direction perpendicular to the parallel plane. That is, a light extraction direction is a vertical direction with respect to the resonance direction (in-plane parallel to the photonic crystal layer).

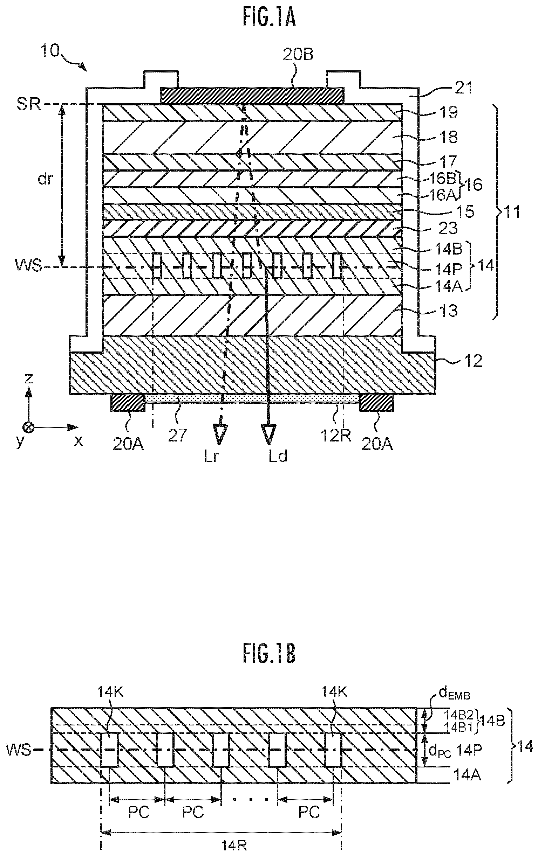

FIG. 1A is a cross-sectional view schematically illustrating an example of a structure of a photonic-crystal surface-emitting laser element (a PCSEL element) 10 according to a first embodiment of the present invention. As illustrated in FIG. 1A, a semiconductor structure layer 11 is formed on a translucent substrate 12. In addition, the semiconductor structure layer 11 is made of a hexagonal nitride semiconductor. The semiconductor structure layer 11 is made of, for example, a GaN-based semiconductor.

More specifically, the semiconductor structure layer 11 including a plurality of semiconductor layers is formed on the substrate 12, that is, an n-clad layer (first conductivity-type first clad layer) 13, an n-side guide layer (first guide layer) 14 that is a guide layer provided on the n side, a light distribution adjustment layer 23, an active layer 15, a p-side guide layer (second guide layer) 16 that is a guide layer provided on the p side, an electron blocking layer (EBL) 17, a p-clad layer (second conductivity-type second clad layer) 18, and a p-contact layer 19 are formed in this order. A case where a first conductivity type is an n type and a second conductivity type that is an opposite conductive type of the first conductivity type is a p type will be described, but the first conductivity type and the second conductivity type may be a p type and an n type, respectively.

The n-side guide layer 14 includes a lower guide layer 14A, the air-hole layer 14P that is a photonic crystal layer (PC layer), and an embedded layer 14B. The embedded layer 14B includes a first embedded layer 14B 1 and a second embedded layer 14B2.

In the present specification, an "n side" and a "p side" do not necessarily mean having an n type and a p type. For example, the n-side guide layer means a guide layer provided closer to the n-side than the active layer, and may be an undoped layer (or an i layer).

In addition, the n-clad layer 13 may include a plurality of layers instead of a single layer, and in this case, all the layers need not be n layers (n-doped layers), and may include an undoped layer (i layer). The same applies to the guide layer 16 and the p-clad layer 18. In addition, it is not necessary to provide all the above-described semiconductor layers, and a configuration may be adopted as long as the configuration includes an n-type semiconductor layer, a p-type semiconductor layer, and an active layer (light emission layer) interposed between these layers.

In addition, an n-electrode (cathode) 20A (electrode of a first polarity) is formed on the rear surface of the substrate 12, and a p-electrode (anode) 20B (electrode of a second polarity) is formed on the p-contact layer 19 (upper surface). The side surface of the semiconductor structure layer 11 and the side surface of the upper portion of the substrate 12 are coated with an insulating film 21 such as SiO₂. In addition, the side surface of the p-electrode 20B and the front surface of the p-contact layer 19 are coated with the insulating film 21 so as to cover the edge portion of the upper surface of the p-electrode 20B. In addition, the front surface of the p-electrode 20B (reflection layer) functions as a reflection surface, and an anti-reflection film 27 is provided on the rear surface of the substrate 12.

Radiated light of the active layer 15 is diffracted by the air-hole layer (PC layer) 14P. Light (the direct diffracted light Ld: first diffracted light) diffracted by the air-hole layer 14P and directly emitted from the air-hole layer 14P, and light (the reflected diffracted light Lr: second diffracted light) emitted due to diffraction of the air-hole layer 14P and reflected by the p-electrode 20B are emitted to the outside from a light emission region 20L of the rear surface (emission surface) 12R of the substrate 12.

FIG. 1B is an enlarged cross-sectional view schematically illustrating the air-hole layer 14P (photonic crystal layer) of FIG. 1A and air holes 14K arranged in the air-hole layer 14P. The air holes 14K have the periods PC, for example, in a square lattice shape on a crystal growth plane (growth plane of the semiconductor layer), that is, a plane parallel to the n-side guide layer 14, and the air holes 14K are formed to be two-dimensionally arranged at square lattice point positions, respectively and embedded in the n-side guide layer 14.

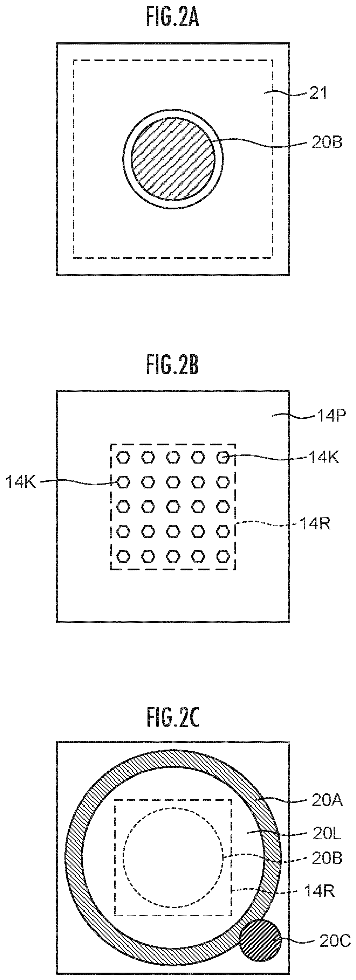

FIG. 2A is a plan view schematically illustrating the upper surface of the PCSEL element 10, FIG. 2B is a cross-sectional view schematically illustrating a cross section of the air-hole layer 14P in a plane parallel to the n-side guide layer 14, and FIG. 2C is a plan view schematically illustrating the lower surface of the PCSEL element 10.

As illustrated in FIG. 2B, in the air-hole layer 14P, the air holes 14K are periodically arranged and provided in, for example, a rectangular air hole forming region 14R. As illustrated in FIG. 2C, the n-electrode (cathode) 20A is provided as an annular electrode on the outside of the air hole forming region 14R not to overlap the air hole forming region 14R when viewed from a vertical direction with respect to the air-hole layer 14P. A region inside the n-electrode 20A is the light emission region 20L. In addition, a bonding pad 20C that is electrically connected to the n-electrode 20A and is connected to a wire for supplying power from the outside is included.

### 2. Manufacturing Step of PCSEL Element 10

Hereinafter, the manufacturing step of the PCSEL element 10 according to the first embodiment of the present invention will be described in detail. The metalorganic vapor phase epitaxy (MOVPE) method is used as a crystal growth method, and the semiconductor structure layer 11 was grown on the growth substrate 12 by normal pressure (atmospheric pressure) growth. In the steps described below, Sn means step n.

In addition, unless otherwise specified, a layer thickness, a carrier concentration, group 3 (group III) and group 5 (group V) raw materials or the like, and a temperature or the like illustrated below are merely examples.

### (S1) Substrate Preparation Step

A GaN single crystal with a +c-plane in which a main surface is a {0001} plane on which Ga atoms are arranged on the outermost front surface is prepared. The main surface may be just-aligned or may be, for example, a substrate that is offset to about 1° in an m-axis direction. For example, a substrate that is offset to about 1° in the m-axis direction can obtain mirror growth under a wide range of growth conditions.

A substrate surface (rear surface) provided with the light emission region 20L opposite to the main surface is a "-c"-plane that is a (000-1) plane in which N atoms are arranged on the outermost front surface. The -c-plane is resistant to oxidation or the like, and is thus suitable as a light extraction surface.

In this example, an n-type GaN single crystal is used as the GaN substrate 12. The n-type GaN substrate 12n has the function of a contact layer with an electrode.

### (S2) N-clad Layer Forming Step

An n-type Al_{0.04}Ga_{0.96}N layer having an Al composition of 4% is grown as the n-clad layer 13 on the +c-plane GaN substrate 12 with a layer thickness of 2 µm. In addition, Si doping is performed, and the carrier concentration at room temperature is approximately 4 × 10¹⁷ cm⁻³.

### (S3a) (Forming Step of Lower Guide Layer + Air Hole Preparation Layer)

Subsequently, n-type GaN is grown as the n-side guide layer 14 with a layer thickness of 360 nm. Si doping is performed, and the carrier concentration is approximately 4 × 10¹⁷ cm⁻³. The growth layer is a preparation layer for forming the lower guide layer 14A and the air-hole layer 14P.

In the following, for simplicity of description and ease of understanding, the substrate 12 on which such a growth layer is formed (growth layer attachment substrate) may be simply referred to as the substrate.

### (S3b) Hole Forming Step

After forming the preparation layer described above, the substrate is taken out from the chamber of an MOVPE apparatus, and fine hole portions (holes) are formed on the growth layer front surface. After a clean front surface is obtained by washing, a silicon nitride film (SiNₓ) is formed into a film using plasma CVD. An electron beam drawing resist is applied thereon by spin coating and placed in an electronic drawing apparatus to perform patterning of a two-dimensional period structure.

Hereinafter, a case where the air-hole layer 14P is a double lattice photonic crystal layer is used as an example, and a method of forming the same will be described, but the formation can be performed in the same manner also in a single lattice photonic crystal layer. In the first embodiment of the present invention, the air-hole layer 14P is a single lattice photonic crystal layer, and is a double lattice photonic crystal layer in a second embodiment.

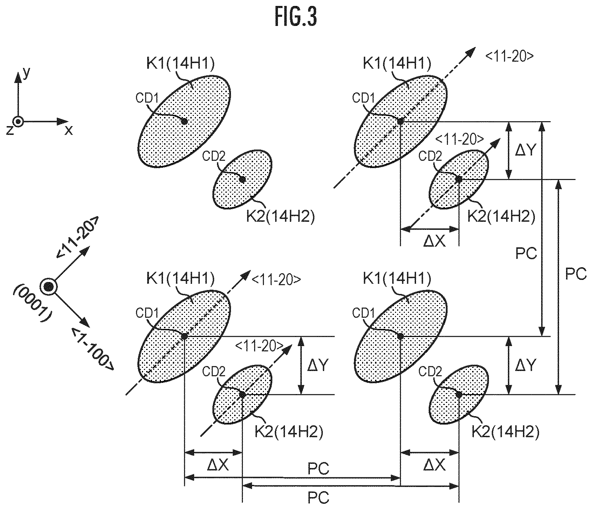

FIG. 3 is a plan view schematically illustrating a main opening K1 and a secondary opening K2 of a resist, and holes 14H1 and 14H2 after etching. As illustrated in FIG. 3, patterning is performed by two-dimensionally arranging a pair of openings including the main opening K1 having an oval shape and the secondary opening K2 smaller than the main opening K1 in a square lattice shape in a plane of the resist with the period PC. For the sake of clarity in the drawings, the openings are hatched.

More specifically, centroids CD1 of the main openings K1 are arranged in a square lattice shape with the period PC in two directions (x-direction and y-direction) that are orthogonal to each other. Similarly, centroids CD2 of the secondary openings K2 are arranged in a square lattice shape with the period PC in the x-direction and the y-direction.

The major axis of the main opening K1 and the secondary opening K2 is parallel to a <11-20> direction of a crystal orientation, and the minor axis of the main opening K1 and the secondary opening K2 is parallel to a <1-100> direction. In the first embodiment, the opening K1 has a long diameter of 83.4 nm and a short diameter of 77.6 nm, and the long diameter/short diameter ratio is 1.1.

In addition, the centroid CD2 of the secondary opening K2 is separated from the centroid CD1 of the main opening K1 by Δx and Δy. Here, Δx = Δy is set. That is, the centroid CD2 of the secondary opening K2 is separated from the centroid CD1 of the main opening K1 in the <1-100> direction.

After the patterned resist is developed, a SiNₓ film is selectively dry-etched by using an inductive coupled plasma reactive ion etching (ICP-RIE) apparatus. As a result, the main opening K1 and the secondary opening K2, which are arranged in a square lattice shape with the period PC, are formed to penetrate the SiNₓ film.

In addition, by setting an emission wavelength (λ) to 435 nm and a refractive index (n) of GaN to 2.46, the period (air hole interval) PC is calculated as PC = λ/n = 176 nm.

Subsequently, the resist is removed, and hole portions (holes) are formed in a GaN front surface portion by using the patterned SiNₓ film as a hard mask. The hole portions (holes) 14H1 and 14H2, which are dug vertically on a GaN front surface and are oblong columnar air holes, are formed by dry-etching GaN in a depth direction by using a chlorine-based gas and an argon gas in the ICP-RIE apparatus.

The shape of the hole is not limited to the oblong columnar shape, and may be a columnar shape, a polygonal shape, or the like. In addition, in a case where the holes 14H1 and 14H2 are not particularly distinguished, the holes 14H1 and 14H2 may be referred to as holes 14H.

In addition, in the present step, in order to distinguish a hole dug in the GaN front surface portion by the etching from the air hole in the air-hole layer 14P, the hole is simply referred to as a hole.

In order to confirm the influence of the interference phase of the direct diffracted light Ld and the reflected diffracted light Lr on the slope efficiency, seven types of photonic crystals having the periods PC of 173, 174, 175, 176, 177, 178, and 179 nm are manufactured. Here, by setting the emission wavelength as λ and setting the refractive index (n) of GaN to 2.46, the period of PC is calculated as PC = λ/n.

As described above, in the first embodiment, the air-hole layer 14P is a single lattice photonic crystal layer. That is, in the hole forming step (S3b), the one hole 14H1 arranged at a square lattice position with the period PC is formed.

### (S3c) Washing Step

The substrate on which the hole 14H1 is formed is subjected to degreasing and washing, and then the SiNₓ film is removed with buffered phosphoric acid (HF). After removing the SiNₓ film, the substrate is immersed in a semiconductor cleaning solution (SemicoClean23, manufactured by Furuuchi Chemical Co., Ltd.) containing about 1% of tetramethylammonium hydroxide (TMAH) for 10 minutes, and then is washed with water.

### (S3d) Embedded Layer Forming Step

This substrate is introduced into a reactor of the MOVPE apparatus again, ammonia (NH₃), trimethyl gallium (TMG), and NH₃ are supplied to close the opening of the hole 14H1, and the first embedded layer 14B1 is formed.

In this first temperature region, since N atoms adhere to the outermost front surface of the growth substrate, an N-polar plane is selectively grown. Therefore, {1-101} facets are selectively grown on the front surface. The holes 14H1 are closed and embedded when the facing {1-101} facets collide with each other. As a result, the first embedded layer 14B1 is formed.

Subsequently, the main hole 14H1 and the secondary hole 14H2 are closed, and then the second embedded layer 14B2 having a thickness of 100 nm is grown. The growth of the second embedded layer 14B2 is performed by lowering a substrate temperature to 820°C (second embedment temperature) and then supplying triethylene gallium (TEG), trimethylindium (TMI), and NH₃. The second embedment temperature was lower than a first embedment temperature.

In addition, the In composition of the second embedded layer 14B2 in the present example is 3% (that is, Ga_{0.97}In_{0.03}N layer). The second embedded layer 14B2 also functions as a light distribution adjustment layer for adjusting the bonding efficiency (light field) between the light and the air-hole layer 14P.

By the above embedment step, the air-hole layer 14P having a double lattice structure is formed in which an air hole pair 14K including a main air hole 14K1 and a secondary air hole 14K2 is disposed at each of the square lattice points. A layer thickness of the formed air-hole layer 14P is 60 nm, and a layer thickness of the embedded layer 14B is 100 nm.

In addition, the light distribution adjustment layer 23 is grown on the embedded layer 14B. The light distribution adjustment layer 23 is an undoped In_{0.03}Ga_{0.97}N layer, and the layer thickness is 50 nm.

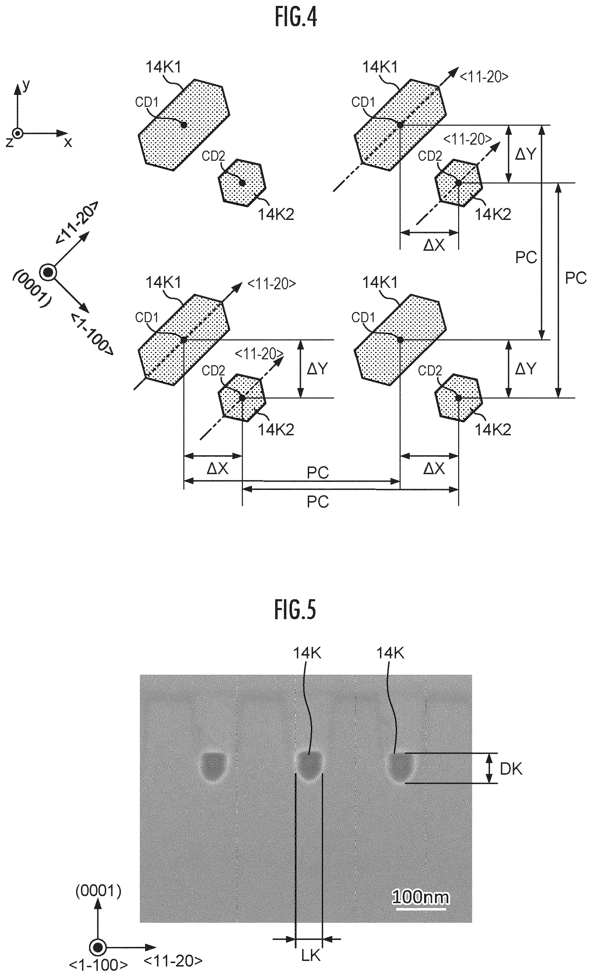

FIG. 4 is a diagram schematically illustrating a cross section of the formed air-hole layer 14P, perpendicular to a crystal layer. When the holes are embedded in group 3 nitride, the shapes of the holes 14H1 and 14H2 are deformed into shapes configured with thermally stable surfaces by mass transport, and air holes 15K1 and 15K2 are formed. That is, in a +c-plane substrate, the shape of the inner side surface of the air hole changes to a (1-100) plane (that is, m plane). That is, the shape changes from an oblong columnar shape to a long hexagonal columnar shape whose side surfaces are configured with the m-plane.

As described above, in the first embodiment, the air-hole layer 14P having a single lattice structure, in which the air hole 14K1 illustrated in FIG. 4 is disposed at each of the square lattice points, is formed by the embedment step. In the present specification, the air hole in the single lattice structure of the first embodiment will be described as the air hole 14K.

In FIG. 5, a cross-sectional scanning electron microscope (SEM) observation is performed to confirm the shape of the embedded air hole 14K in the first embodiment. The cross-sectional SEM image is illustrated in FIG. 5.

A long diameter (length of the major axis) LK of the air hole 14K is 57.6 nm, a short diameter WK (length of the minor axis) is 50.1 nm (long diameter/short diameter = 1.15), and a depth DK is 60 nm. That is, it is confirmed that the air-hole layer 14P is formed in which the air hole 14K having a regular hexagonal columnar shape is disposed at each of the square lattice points with the period PC = 173, 174, 175, 176, 177, 178, and 179 nm.

In addition, an air hole filling ratio FF of the air hole 14K is about 7.1%. The percentage of a value obtained by dividing an air hole area as viewed from a direction orthogonal to the plane of the air-hole layer 14P by the square of the period PC of the air hole, is referred to as the air hole filling ratio FF (filling factor).

In addition, the major axis of the air hole 14K is disposed to be parallel to an <11-20> axis (that is, an a-axis) of the crystal.

### (S4) Light Emission Layer Forming Step

Subsequently, a multiple quantum well (MQW) layer having two quantum well layers is grown as the active layer 15 that is a light emission layer. The MQW barrier layer and quantum well layer are GaN (layer thickness of 6.0 nm) and InGaN (layer thickness of 3.0 nm), respectively. A center wavelength of photoluminescence (PL) emission from the active layer in the present embodiment is 435 nm.

The active layer 15 is disposed within 180 nm from the air hole in the air-hole layer 14P, and the distance is set such that the resonance effect due to the air-hole layer 14P is sufficiently obtained.

### (S5) p-side Guide Layer Forming Step

After the active layer 15 grows, an undoped In_{0.02}Ga_{0.98}N layer (layer thickness: 70 nm) is grown as a p-side guide layer (1) 16A, and an undoped GaN layer (layer thickness of 180 nm) is grown as a p-side guide layer (2) 16B thereon. The p-side guide layer 16 includes the p-side guide layer (1) 16A and the p-side guide layer (2) 16B.

The p-side guide layer 16 is set to be an undoped layer in consideration of light absorption by a dopant (Mg: magnesium or the like), but may be doped in order to obtain good electrical conductivity. In addition, in order to adjust the electric field distribution in the oscillation operation mode, the In composition and the layer thickness of the p-side guide layer (1) 16A can be appropriately selected.

### (S6) Electron Blocking Layer Forming Step

After the growth of the p-side guide layer 16 is carried out, the electron blocking layer (EBL) 17 is grown. The electron blocking layer 17 is an Al_{0.2}Ga_{0.8}N layer (layer thickness of 15 nm), and is Mg-doped using Cp2Mg.

### (S7) p-clad Layer Forming Step

After the growth of the electron blocking layer (EBL) 17 is carried out, an Mg-doped p-Al_{0.06}Ga_{0.94}N layer (layer thickness of 595 nm) is grown as the p-clad layer 18.

The carrier concentration of the p-clad layer 18 is 2 × 10¹⁷ cm⁻³ when activated at 850°C for 10 minutes in an N₂ atmosphere after the growth.

In addition, the Al composition ratio of the p-clad layer 18 is set to be smaller than the refractive index of the p-side guide layer 16.

### (S8) P-contact Layer Forming Step

After the p-clad layer 18 is grown, the Mg-doped p-GaN layer (layer thickness of 25 nm) is grown to form the p-contact layer 19.

### (S9) Electrode Forming Step

The surface of the p-contact layer 19 of the growth layer attachment substrate on which the formation of an epitaxial growth layer is completed is attached to a support substrate, and the substrate 12 is thinned to a predetermined thickness by a grinding apparatus.

Then, a mask covering other than an element separation groove is formed on the side of the p-contact layer 19 and etching is performed until the n-clad layer 13 or the substrate 12 is exposed. Then, the mask is removed, and the support substrate is removed to form the element separation groove.

### (S10) Electrode Forming Step

### (Anode Electrode Formation)

A palladium (Pd) film and a gold (Au) film are formed into films on the front surface of the epitaxial growth substrate 12 as the p-electrode 20B (anode electrode) in this order by an electron beam vapor deposition method. The formed electrode metal film is patterned using photolithography in a size of 200 × 200 µm² to form the p-electrode 20B.

The p-electrode 20B is preferably a material that reflects the light emitted from the active layer 15, which can be selected from Pd/Ag/Pt/Au, Pd/Ag/Pd/Au, Pd/Pt/Au, Ni/Pd/Au, Ni/Pt/Au, Ni/Rh/Au, Ni/Ag/Pd/Au, Ni/Ag/Pt/Au, Pt/Au, or the like in addition to Pd/Au.

In addition, the size of the p-electrode 20B is preferably included in the air hole forming region 14R when viewed from a vertical direction with respect to the air-hole layer 14P (also referred to as top view) and is preferably smaller than the air hole forming region 14R. This is because an injection current is narrowed and concentrated in the air hole forming region 14R. In addition, as an electrode material of the p-electrode 20B, a dielectric film having conductivity such as ITO or the like other than metal may be selected.

### (Cathode Electrode Formation)

Subsequently, Ti and Au are sequentially formed into a film on the rear surface of the substrate 12 by an electron beam vapor deposition method to form the n-electrode 20A (cathode electrode). In addition to Ti/Au, the n-electrode 20A can be selected from Ti/Al, Ti/Rh, Ti/Al/Pt/Au, Ti/Pt/Au, or the like. In addition, the bonding pad 20C that is connected to a wire for supplying power is included.

### (S11) Protective Film Forming Step

The bottom surface of the substrate for which the electrode is formed is attached to the support substrate, and a mask covering the anode electrode is formed. Then, a SiO₂ film that is the protective film 21 is formed on the upper surface and the side surface of an element by sputtering.

The protective film 21 protects the crystal layer containing aluminum (Al) forming the PCSEL element 10 from a corrosive gas or the like. In addition, the protection is also provided from a short circuit due to a deposit.

### (S12) Individualization Step

Finally, the laser scribing is performed along the center line of a substrate separation groove to obtain the individualized PCSEL element 10.

### [Second Embodiment]

### 1. Structure of Photonic-Crystal Surface-Emitting Laser

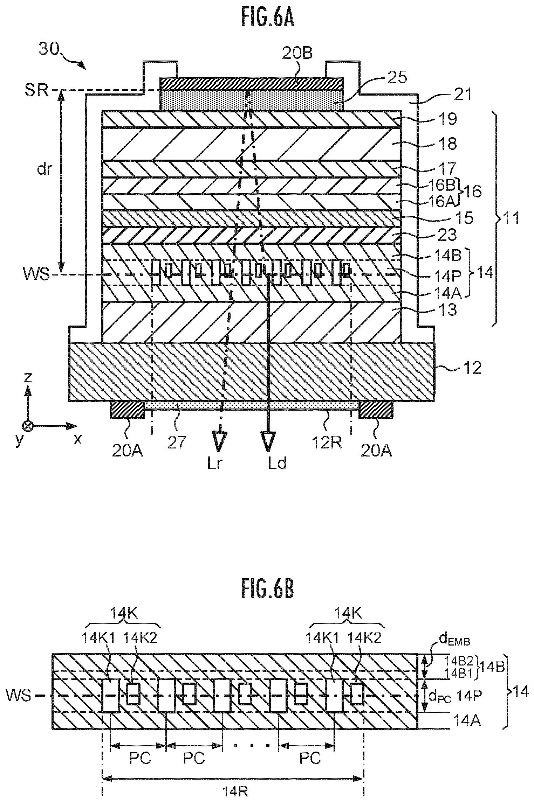

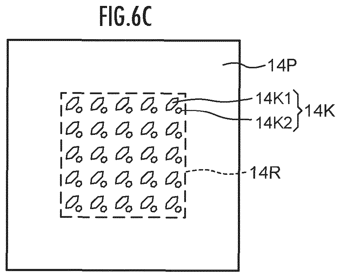

FIG. 6A is a cross-sectional view schematically illustrating an example of a structure of a PCSEL element 30 according to the second embodiment of the present invention. FIG. 6B is an enlarged cross-sectional view schematically illustrating the air-hole layer 14P of FIG. 6A and an air hole pair 14K including the main air hole 14K1 and the secondary air hole 14K2 arranged in the air-hole layer 14P. In addition, FIG. 6C is a cross-sectional view schematically illustrating a cross section of the air-hole layer 14P in a plane parallel to the air-hole layer 14P.

As illustrated in FIG. 6C, the air hole pair 14K has the period PC in a plane parallel to the air-hole layer 14P, for example, in a square lattice shape. The air-hole layer 14P is formed by having the air hole pairs 14K embedded in the n-side guide layer 14 two-dimensionally arranged at each of square lattice point positions.

In addition, in the same manner as the PCSEL element 10 of the first embodiment (see FIG. 2C), also in the PCSEL element 30, the light (the direct diffracted light Ld) directly emitted from the air-hole layer (PC layer) 14P and the light (the reflected diffracted light Lr) emitted from the air-hole layer 14P and reflected by the p-electrode 20B are emitted to the outside from the light emission region 20L of the rear surface (emission surface) 12R of the substrate 12.

The PCSEL element 30 according to the second embodiment is different from the PCSEL element 10 according to the first embodiment in the following points.
(1) In the PCSEL element 30, the transparent conductor film 25 (translucent conductor film) including a metal oxide, specifically indium tin oxide (ITO) having a thickness of 145 nm, between the p-contact layer 19 and the p-electrode 20B, is provided. The transparent conductor film 25 also functions as a second p-clad layer.
   In addition, as the p-electrode 20B, an Ag film having a thickness of 50 nm and an Au film having a thickness of 300 nm are sequentially formed to be films by an electron beam vapor deposition method. The formed electrode film is patterned into a circle with a diameter of 300 µm by photolithography to form the p-electrode 20B. In the second embodiment, a reflection surface SR is positioned at an interface between the transparent conductor film 25 (ITO film) and the Ag film of the p-electrode 20B.
(2) In the PCSEL element 30, the air-hole layer 14P is a double lattice photonic crystal layer. In addition, the depth (that is, layer thickness) of the air hole 14K1 of the air-hole layer 14P is 90 nm, which is thicker than the 60 nm of the PCSEL element 10 of the first embodiment.
(3) In the PCSEL element 30, the layer thickness of the embedded layer 14B is 90 nm, and is 100 nm in the PCSEL element 10 of the first embodiment. In addition, the layer thickness of the p-clad layer 18 is 290 nm, and is 595 nm in the PCSEL element 10 of the first embodiment.

### 2. Main Air Hole and Secondary Air Hole in Second Embodiment

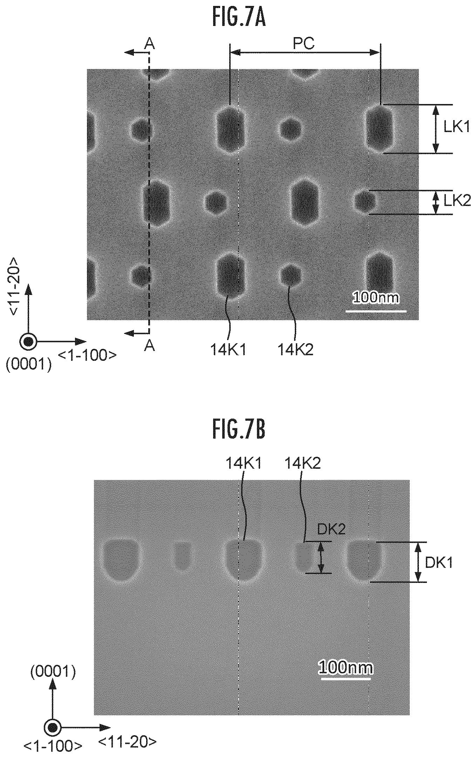

In order to confirm the shape of the embedded air hole in the second embodiment, a laminate structure is processed with a focused ion beam (FIB) from the front surface until the air hole in the air-hole layer is exposed, and then SEM observation is performed. The upper surface SEM image of FIG. 7A illustrates the air hole shapes of the main air hole 14K1 and the secondary air hole 14K2 having a size smaller than the main air hole 14K1 at this time. In addition, FIG. 7B is an SEM image illustrating a cross section of FIG. 7A along a line A-A. The secondary air hole 14K2 is preferably smaller in at least one of an air hole diameter and a depth than the main air hole 14K1.

In the same manner as in the case of the first embodiment, in order to confirm the effect of the interference of the reflected diffracted light Lr and the direct diffracted light Ld, three types of double lattice air-hole layers with the periods PC of 173, 174, and 175 nm are manufactured. FIGS. 7A and 7B are SEM images of the air-hole layer at PC = 175 nm.

As illustrated in FIG. 7A, a long diameter LK1 of the main air hole 14K1 having a long hexagonal shape is 82.5 nm, and a short diameter W is 45.8 nm (long diameter/short diameter = 1.80). The secondary air hole 14K2 has a long diameter (LK2) of 42.5 nm and a short diameter of 37.1 nm (long diameter/short diameter = 1.15), and has a regular hexagonal shape.

As illustrated in FIG. 7B, a depth DK1 of the main air hole 14K1 is 91.4 nm, and a depth DK2 of the secondary air hole 14K2 is 64.6 nm. In addition, the upper end of the secondary air hole 14K2 is at a position 7.6 nm deeper than the upper end of the main air hole 14K1, and the lower end of the secondary air hole 14K2 is at a position 19.3 nm shallower than the lower end of the main air hole 14K1.

Air hole filling ratios FF1 and FF2 of the main air hole 14K1 and the secondary air hole 14K2 are 10.1% and 3.8%, respectively. The air hole filling ratio in the double lattice photonic crystal is a ratio of the area occupied by each air hole per unit area, and when it is assumed that the areas of the main air hole 14K1 and the secondary air hole 14K2 are S1 and S2, respectively, the air hole filling ratios FF1 and FF2 of the main air hole 14K1 and the secondary air hole 14K2 are given by the following expressions.$FF 1 = S 1 / {PC}^{2} , FF 2 = S 2 / {PC}^{2}$ (1)

In addition, the distances Δx and Δy (Δx = Δy) of the centroid CD1 of the main air hole 14K1 and the centroid CD2 of the secondary air hole 14K2 in the x-axis and y-axis directions are 0.45 × PC, and have not changed since before the embedment. In addition, the major axes of the main air hole 14K1 and the secondary air hole 14K2 are disposed to be parallel to the <11-20> axis (that is, the a-axis). The centroid in-between distances of the centroid CD1 of the main air hole 14K1 and the centroid CD2 of the secondary air hole 14K2 are set as Δx = Δy, and the centroid CD2 of the secondary air hole 14K2 is separated in the <1-100> direction with respect to the centroid CD1 of the main air hole 14K1.

### <Theoretic Analysis and Consideration: Diffraction of Light in Photonic Crystal>

### (1) Emission Efficiency and Diffraction of Light

### (1.1) Emission Direction of Laser Light in PCSEL Element

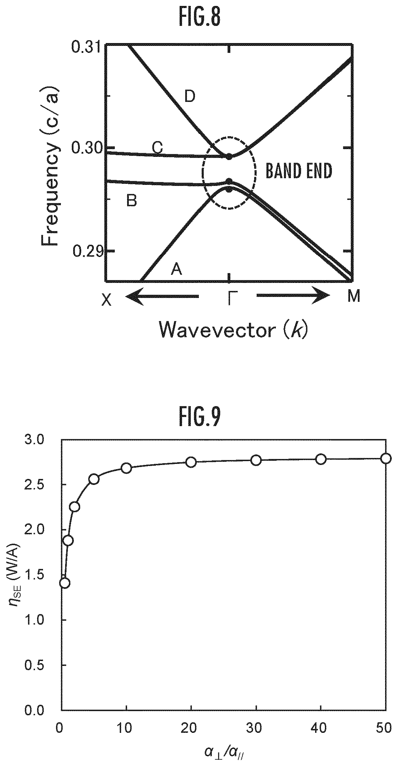

In the PCSEL elements of Embodiments 1 and 2, the air-hole layer, which is a photonic crystal layer, has a photonic band structure as illustrated in FIG. 8. The resonance action is obtained at a frequency (wavelength) at a band end in which the group speed of the band structure is zero. At the band end of such a photonic band, an in-plane wave number k is zero.

Therefore, when the air-hole layer (photonic crystal layer) is on an xy plane, light propagating in the air-hole layer forms a standing wave in the xy plane, and a part of the light is diffracted by the photonic crystal in the z-axis direction orthogonal to the xy plane and emitted as laser light.

That is, in the above embodiment, since the reflection surface SR is on the xy plane parallel to the air-hole layer 14P, laser light diffracted by the air-hole layer 14P and the reflection surface SR are orthogonal to each other.

### (1.2) Emission Efficiency in Consideration of Reflection of Reflection Surface

### (1.2.1) Slope Efficiency of PCSEL element

A resonator loss in the PCSEL element is divided into a loss component αp in an inward direction (parallel direction) of the same plane (xy plane) as the air-hole layer 14P, and a loss component αn in a direction (orthogonal direction: z-axis direction) emitted by diffraction.

Of these, the component αn in a vertical direction contributes to the emission of the laser, but in a case where the reflection surface SR is present, it is necessary to consider an emission efficiency in consideration of the absorption and the reflection on the reflection surface SR.

Assuming that the electric field amplitude of laser light radiated in the vertical direction by the diffraction is E₀e^{ikz} (an energy intensity is |E₀e^{ikz}|²), when the diffraction occurs evenly in +z and -z directions, the laser light radiated in the +z and -z direction is (1/2^{1/2})E₀e^{ikz}. Assuming that an amplitude reflectivity on the reflection surface SR is r (energy reflectivity R = r²), an absorbed component and a reflected component on the reflection surface SR of the laser light radiated in the +z direction (upward direction: direction of the reflection surface SR) are represented by the following expressions, respectively.$\frac{\sqrt{1 - {r}^{2}}}{\sqrt{2}} {E}_{0} {e}^{ikz} , \frac{r}{\sqrt{2}} {E}_{0} {e}^{ikz}$

Therefore, the direct diffracted light Ld and the reflected diffracted light Lr can be represented as follows, respectively.$\frac{1}{\sqrt{2}} {E}_{0} {e}^{ikz} , \frac{r}{\sqrt{2}} {E}_{0} {e}^{ikz}$

In the present specification, the loss αn in a vertical direction, the loss αp in an in-plane direction, a component αn_down, which is emitted from an emission surface and contributes to laser emission, in the loss αn in a vertical direction, a component αn_up that is absorbed by the reflection surface SR and does not contribute to the laser emission, and a slope efficiency ηSE are respectively expressed as follows.

*α*_{⊥}, *α*_{//}, *α*_{⊥*down*}, *α*_{⊥*up*}, *η_{SE}*

Assuming that a phase difference between the direct diffracted light Ld and the reflected diffracted light Lr at a wave source position is θ, the laser light (sum of Ld and Lr) emitted from the emission surface is represented by the following expressions.$\frac{1}{\sqrt{2}} {E}_{0} {e}^{ikz} + \frac{r}{\sqrt{2}} {E}_{0} {e}^{i \left(kz+θ\right)} = \frac{1}{\sqrt{2}} {E}_{0} \left(1+{re}^{θ}\right) {e}^{ikz}$ (2-1)

Considering that the square of the absolute value of an electric field component is energy, the component αn_down, which is emitted from the emission surface 12R (the rear surface of the substrate 12) and contributes to the laser emission, in the loss αn in the vertical direction is represented by the following expression.${α}_{⊥ down} = {\left|\frac{1}{\sqrt{2}}\left(1+{re}^{θ}\right)\right|}^{2} {α}_{⊥} = \frac{1}{2} \left(1+2\sqrt{R} cos θ+R\right) {α}_{⊥}$ (2-2)

On the other hand, the component αn_up that is absorbed by the reflection surface SR and does not contribute to the laser emission is represented by the following expressions.${α}_{⊥ up} = {\left|\frac{\sqrt{1 - R}}{\sqrt{2}}\right|}^{2} {α}_{⊥} = \frac{1}{2} \left(1-R\right) {α}_{⊥}$ (2-3) here, *α*_{⊥} = *α*_{⊥*up*} + *α*_{⊥*down*}

From the above, when the slope efficiency ηSE (emission efficiency) is obtained in a case where the reflection surface SR in the PCSEL element is considered, the slope efficiency ηSE is represented by the following expression.${η}_{SE} = \frac{hν}{e} {η}_{i} \frac{{α}_{⊥ down}}{{α}_{⊥ _ up} + {α}_{⊥ _ down} + {α}_{/ /} + {α}_{i}} = \frac{hν}{e} {η}_{i} \frac{\frac{1}{2} \left(1+2\sqrt{R} cos θ+R\right) {α}_{⊥}}{\left(1+\sqrt{R} cos θ\right) {α}_{⊥} + {α}_{/ /} + {α}_{i}}$ (2-4)

In the above expression, ηi is an injection efficiency during a laser oscillation operation. In addition, in the above expression, in addition to the resonator loss, a loss (internal loss) αi due to material absorption is considered.

### (1.2.2) Range of Phase Difference θ between Direct Diffracted Light Ld and Reflected Diffracted Light Lr that Enhances Emission Efficiency

When the internal loss αi = 0, Expression (2-4) is represented by the following expression. That is, the larger αn/αp is, the higher the slope efficiency ηSE can be.${η}_{SE} = \frac{hν}{e} {η}_{i} \frac{\frac{1}{2} \left(1+2\sqrt{R} cos θ+R\right)}{\left(1+\sqrt{R} cos θ\right) + \frac{{α}_{/ /}}{{α}_{⊥}}}$ (2-5)

Then, in the ideal case of ηi = 1, the reflectivity R = 1, and θ = 0, the slope efficiency ηSE with respect to αn/αp is illustrated in FIG. 9. When αn/αp is about 20, the slope efficiency ηSE is saturated. From the viewpoint of increasing the slope efficiency ηSE, it can be said that αn is preferably about 20 times greater than αp or more.

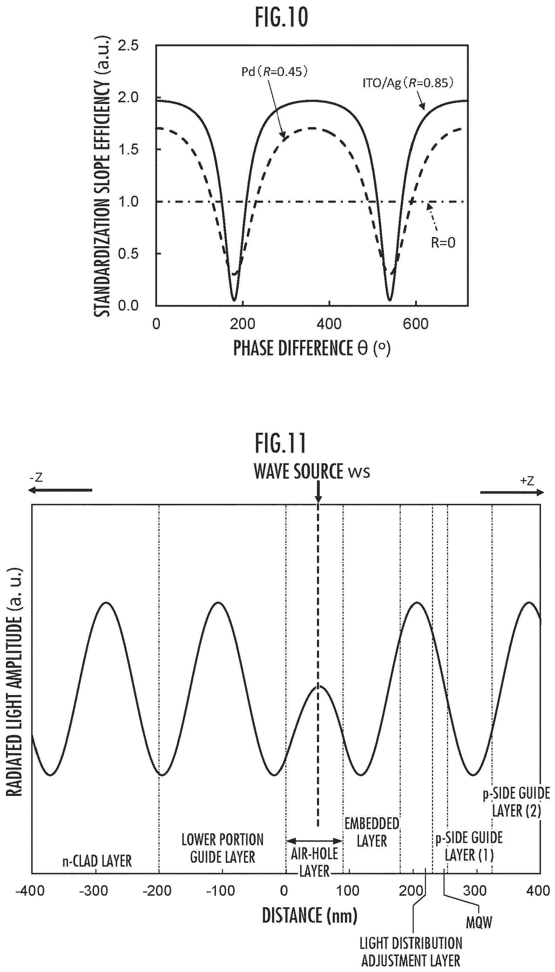

When αn/αp=20 and Pd (palladium) (the reflectivity R is about 0.45) or ITO/Ag (the reflectivity R is about 0.85), which is generally used as a p-electrode material of a GaN-based device for a reflection electrode material is used as the reflection surface SR, FIG. 10 illustrates the dependence of a slope efficiency with respect to the phase difference θ, which is standardized by a slope efficiency when there is no reflection by the reflection surface SR.

As illustrated in FIG. 10, in order to increase the slope efficiency (emission efficiency) as compared with a case where there is no reflection, the phase difference θ in each electrode material needs to be in the following range.
· In the case of Pd: 0° ≤ θ < 129.8° or 230.2° < θ < 360°
· In the case of ITO/Ag: 0° ≤ θ < 152.7° or 208.5° < θ < 360°

A distance (separation distance) dr from a wave source (diffraction surface) WS to the reflection surface SR when the phase difference θ is in the above range is obtained. The phase when the reflected diffracted light Lr reciprocates in the dr may be as described above. In other words, in a case where the phase difference θ is in a range exceeding 1.0 of the slope efficiency standardized by the slope efficiency when there is no reflection by the reflection surface SR, the direct diffracted light Ld and the reflected diffracted light Lr strengthen each other, and the slope efficiency ηSE and light intensity (light output) of the combined light are improved. Assuming that an average refractive index of materials constituting the wave source WS to the reflection surface SR with respect to the wavelength λ of emitted light is nₐᵥₑ, the separation distance dr satisfies the following condition when the Pd is the reflection surface SR.

The plane (xy plane), which is a set of the wave sources WS, parallel to the air-hole layer 14P is the diffraction surface WS, which will be described using the same reference numeral, WS for ease of understanding and simplicity of description.$\begin{matrix}\left(\frac{1}{2}+m\right) λ < 2 {n}_{ave} dr < \left(0.861+m\right) λ \\ or , \left(1.139+m\right) λ < 2 {n}_{ave} dr < \left(\frac{1}{2}+m+1\right) λ \\ \left(here, 0\leq 2{n}_{ave}dr-\left(\frac{1}{2}+m\right)λ<1, m is an integer of 0 or more\right)\end{matrix}$ (2-6)

Similarly, when ITO/Ag is used as the reflection surface SR, the separation distance dr satisfies the following condition. $\begin{matrix}\left(\frac{1}{2}+m\right) λ < 2 {n}_{ave} dr < \left(0.921+m\right) λ \\ or , \left(1.079+m\right) λ < 2 {n}_{ave} dr < \left(\frac{1}{2}+m+1\right) λ \\ \left(here, 0\leq 2{n}_{ave}dr-\left(\frac{1}{2}+m\right)λ<1, m is an integer of 0 or more\right)\end{matrix}$ (2-7)

### (1.3) Wave Source (Diffraction Surface) Position

### (1.3.1) Theoretic Analysis of Diffraction in Air-hole Layer

From Non-Patent Document 1, a relationship between light propagating in the air-hole layer in the x-axis direction and light being diffracted and radiated in the vertical direction is represented by the following expression in a coupled wave theory.$\left[\frac{{\partial }^{2}}{\partial {z}^{2}}+{{k}_{0}}^{2}{n}_{0}{\left(z\right)}^{2}\right] {E}_{{y}_{rad}} \left(z\right) = - {{k}_{0}}^{2} \left({ξ}_{- 1 , 0}{R}_{x}+{ξ}_{1 , 0}{S}_{x}\right) {Θ}_{0} \left(z\right)$ (3-1)

In the above expression, k0 is a wave number, and n0(z) is an average refractive index at a certain point on the z-axis of the PCSEL element. The above expression is solved using a green function G(z, z') that satisfies the following expression.$\left[\frac{{\partial }^{2}}{\partial {z}^{2}}+{{k}_{0}}^{2}{n}_{0}{\left(z\right)}^{2}\right] G \left(z,z′\right) = - δ \left(z,z′\right)$ (3-2)

G(z, z') satisfying Expression (3-2) is represented by the following expression.$G \left(z, z′\right) ≅ - \frac{i}{2 {β}_{z}} {e}^{- {iβ}_{z} \left|z-z′\right|}$ (3-3)

When the G(z, z') is used, an Ey_{rad} that satisfies Expression (3-1) is represented by the following expression.${E}_{{y}_{rad}} \left(z\right) = {{k}_{0}}^{2} {\int }_{PC} G \left(z,z′\right) \left({ξ}_{- 1 , 0}\left(z′\right){R}_{x}+{ξ}_{1 , 0}\left(z′\right){S}_{x}\right) {Θ}_{0} \left(z′\right) dz ′$ (3-4)

In Expression (3-4), the following expression represents the relative intensity of light propagating in the xy plane in the air-hole layer in the x-axis direction with respect to light diffracted in the vertical direction.$\left({ξ}_{- 1 , 0}\left(z′\right){R}_{x}+{ξ}_{1 , 0}\left(z′\right){S}_{x}\right) {Θ}_{0} \left(z′\right)$ (3-4-1)

According to Expression (3-4), the electric field amplitude Ey_{rad} of laser light radiated in the vertical direction of the PCSEL element can be expressed by the superimposition of the light diffracted on each surface in the depth direction (z-axis direction) of the air-hole layer. Here, Θ0(z') in Expression (3-4-1) represents an electric field profile of a basic mode of the PCSEL element in the z-axis direction.

The following ξ in Expression (3-4-1) represents a component (hereinafter, also referred to as a vertical direction diffraction component ξ) of each light propagating in the air-hole layer 14P in the +x direction and the -x direction, which is diffracted in the vertical direction by the air hole. In addition, Rx and Sx represent propagation wave intensities in the +x direction and the -x direction, respectively.${ξ}_{- 1 , 0} , {ξ}_{1 , 0}$ (3-4-2)

### (2) Structure Dependence of Wave Source Position and Diffraction Surface

### (2.1) Case of Single Lattice Structure (Single Hole)

### (2.1.1) Structure and Diffraction Surface of PCSEL Element of First Embodiment

A radiated wave radiated in the vertical direction in the PCSEL element 10 of the first embodiment is calculated. More specifically, for the PCSEL element having the same structure as the structure illustrated in the first embodiment (see FIGS. 1A and 1B), after a coupled state of light propagating in the air-hole layer 14P is calculated by using a two-dimensional coupled wave theory, the radiated wave in the vertical direction with respect to the air-hole layer 14P is calculated from Expression (3-4).

The structure of the PCSEL element used in the calculation is the same as the structure of the PCSEL element of the first embodiment except for the following difference. Specifically, in the PCSEL element used for the calculation, the layer thickness of the air-hole layer 14P is 90 nm, and the layer thickness of the embedded layer 14B is 90 nm. In addition, the layer thickness of the p-clad layer 18 is 600 nm.

In the calculation, the air hole filling ratio FF is 10%. In addition, in a nitride material system, when the air holes are embedded in the layer grown on the +c-plane substrate, it is known that the air hole has a hexagonal columnar structure whose side surfaces have the m-plane due to mass transport generated during the embedment growth (for example, WO 2018/155710 A1). Therefore, here, the air hole 14K of the air-hole layer 14P is assumed to have a hexagonal columnar structure having a center axis extending in the z-axis direction, and the calculation is performed. In addition, the air hole period PC is 176 nm.

FIG. 11 illustrates an electric field amplitude of a radiated wave when light propagating in the air-hole layer 14P in the x-axis direction is diffracted by the air hole and radiated in the vertical direction (z-axis direction). An aspect can be seen that the light diffracted by the air-hole layer 14P is radiated, as radiated light, symmetrically in the +z-axis direction and the -z-axis direction at a certain point (a point on the z-axis) as a starting point in the air-hole layer 14P.

Since it can be assumed that the radiated wave is emitted from the starting point (z = z_{ws}) in the air-hole layer 14P, the point is the diffraction surface (wave source) WS in a device. Then, a surface that satisfies z = z_{ws} and is parallel to the air-hole layer 14P is a diffraction surface and functions as a wave source. In the following, for ease of understanding and simplicity of description, the same reference numerals are used and such a surface is described as the diffraction surface WS. In other words, a symmetrical center surface when the light standing in the air-hole layer 14P is diffracted with an electric field amplitude symmetrical in a direction orthogonal to the air-hole layer 14P, is the diffraction surface WS.

As illustrated in FIG. 11, the diffraction surface WS is present slightly in the +z-axis direction from the center of the air-hole layer 14P, that is, at a position closer to the active layer 15. The amplitude of light that is diffracted on the diffraction surface (parallel to the xy plane) in the air-hole layer 14P and radiated in the z-axis direction is determined by Expression (3-4-1).

Therefore, the vertical direction diffraction component ξ is determined by the air hole filling ratio and an air hole shape such as in-plane rotational symmetry, and increases as the air hole filling ratio FF increases and as the in-plane rotational symmetry decreases.

In general, in a semiconductor laser, from the viewpoint of light confinement, the electric field in the basic mode has a profile such that the active layer has a peak. Therefore, the electric field profile Θ0(z') increases as the point is closer to the active layer on the z-axis.

In the group 3 nitride-based (+c-plane, wurzite) PCSEL element, the air hole has a hexagonal columnar structure extending in a c-axis direction (z-axis direction) as described above. That is, in the case of the PCSEL element of the air-hole layer having a single lattice structure, the diffraction component ξ in the vertical direction is equal at any point on the z-axis in the air-hole layer.

On the other hand, since the electric field profile Θ0(z') increases as a point is closer to the active layer, the diffraction surface WS is present at a position slightly biased more to the active layer than the center of the air-hole layer in the z-axis direction. Assuming that the electric field profile Θ0(z') is uniform in the air-hole layer, the diffraction surface WS is present at the center position of the air-hole layer 14P in the z-axis direction.

### (2.1.2) Air-hole Layer Thickness Dependence of Diffraction Surface Position

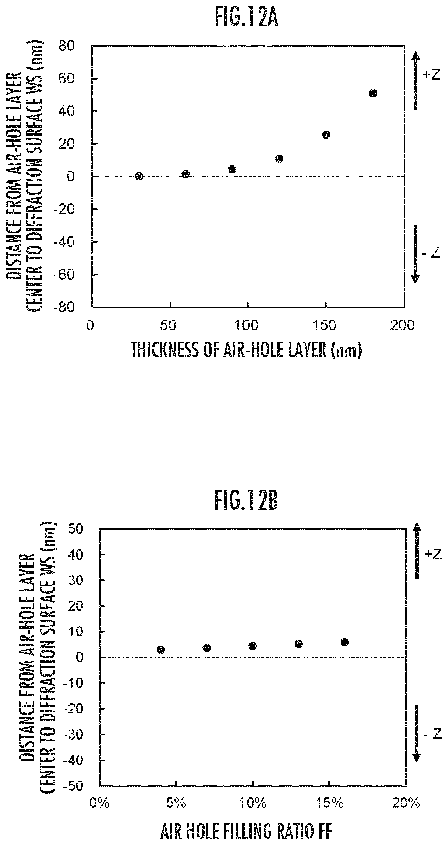

FIG. 12A illustrates a position of the diffraction surface WS with respect to a thickness d_{PC} (see FIG. 1B) of the air-hole layer 14P. The calculation is performed assuming that the thickness d_{PC} of the air-hole layer 14P is changed from 30 nm to 180 nm and the air hole filling ratio FF is 10% and is constant.

In the present specification, the thickness d_{PC} of the air-hole layer 14P is a height of the air hole 14K, that is, a distance between the upper end and the lower end of the air hole 14K, and the center of the air-hole layer and the air hole is a center position between the upper end and the lower end of the air hole 14K.

The thinner the air-hole layer 14P is, the closer the diffraction surface position is to the center of the air hole, and the thicker the air-hole layer 14P is, the more the diffraction surface position is shifted to the side of the active layer 15 (+z-axis direction) from the center. This is because the thicker the air-hole layer 14P is, the larger the difference in the Θ0(z') between the upper end and the lower end of the air hole is and the greater the electric field amplitude of the light diffracted in the z-axis direction is on the side of the active layer 15 than the center of the air-hole layer 14P.

It is preferable that the thickness d_{PC} of the air-hole layer 14P (photonic crystal layer) is set to be a thickness at which an optical path length is less than one wavelength, that is, n × d_{PC} < λ (n is an effective refractive index of the air-hole layer 14P).

This is because, when the thickness of the air-hole layer 14P is thicker than the optical path length of the propagating light, disappearing interference of the radiated waves in the z-axis direction occurs in the air-hole layer 14P. For example, in a case of n × d _{PC} = λ, since the light radiated at the center of the z-axis of the air-hole layer 14P has a phase shift of π exactly at the positions of the upper end and the lower end of the air hole, disappearing interference is caused. Therefore, it is difficult to efficiently emit the laser light in a direction orthogonal to the air-hole layer 14P. Considering that the refractive index of the GaN layer is about 2.46, the thickness of the air-hole layer 14P is preferably about 180 nm or less in the PCSEL element that emits blue light. Therefore, as illustrated in FIG. 12A, the diffraction surface WS of the PCSEL element that emits blue light is present at a position that is 0 to 51 nm away from the center of the air-hole layer 14P in the z-axis direction to the side of the active layer 15.

### (2.1.3) FF Dependence of Diffraction Surface Position

FIG. 12B illustrates a position of the diffraction surface WS when the air hole filling ratio FF is changed in the range of 4% to 16%. The larger the FF is, the more the diffraction surface WS is shifted to the side of the active layer, but although the FF is changed from 4% to 16%, a shift amount from the center of the air-hole layer (PC layer) 14P to the side of the active layer 15 is about a change from 3 nm to 6 nm.

This is because the electric field profile Θ0(z') in the basic mode is roughly determined by the relationship between the core layer (the active layer and the guide layer) and the clad layer. However, as the FF increases, the average refractive index of the air-hole layer 14P decreases, and thus the electric field profile is slightly closer to the side of the active layer, and Θ0(z') at the lower end of the air hole decreases, so that the diffraction surface WS is shifted to the side of the active layer 15 along with the increase of the FF.

### (2.1.4) Embedded Layer Thickness Dependence of Diffraction Surface Position

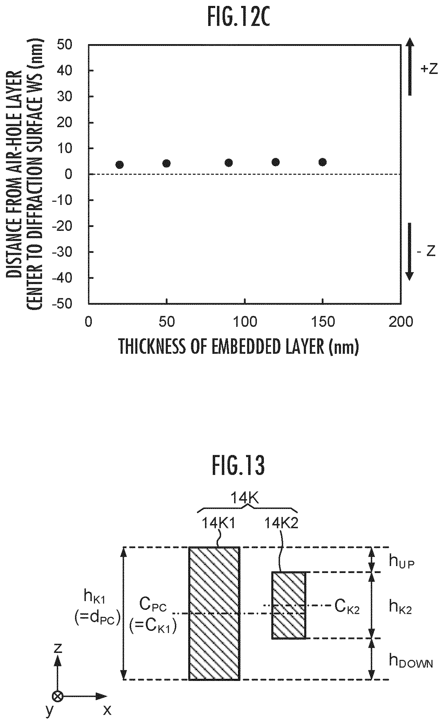

FIG. 12C illustrates a position of the diffraction surface WS when a thickness d_{EMB} (see FIG. 1B) of the embedded layer 14B is changed in the range of 20 nm to 150 nm.

As the embedded layer 14B grows to be thicker, the diffraction surface WS is shifted to the side of the active layer 15 side, but
a shift amount from the center of the air-hole layer 14P to the side of the active layer 15 is about a change from 4 nm to 5 nm and hardly changes.

This is because, as described above, the electric field profile Θ0(z') in the basic mode is roughly determined by the relationship between the core layer (the active layer and the guide layer) and the clad layer. When the thickness of the embedded layer 14B is thin, the guide layer on the n-side is thin, and thus the electric field profile in the basic mode is slightly shifted to the p-side, and as a result, when the embedded layer 14B is thickened, the electric field profile Θ0(z') at the lower end of the air hole decreases, so that the diffraction surface WS is slightly shifted to the side of the active layer 15 as the thickness d_{EMB} increases.

From the above, it can be understood that the position of the diffraction surface WS is relatively strongly dependent on a change in the thickness d_{PC} of the air-hole layer 14P rather than a change in the air hole filling ratio FF and a change in the thickness d_{EMB} of the embedded layer 14B.

### (2.2) Case of Double Lattice Structure (Double Hole)

In the group 3 nitride-based (+c-plane, Wurzite) PCSEL element, the air hole has a hexagonal columnar structure extending in the c-axis direction (z-axis direction) as described above, so that in the case of the PCSEL element of the air-hole layer having a single lattice structure, the diffraction component ξ in the vertical direction is equal at any point on the z-axis in the air-hole layer. That is, from Expression (3-4), in the single lattice structure, the diffraction surface WS is shifted in the air-hole layer 14P as the electric field profile Θ0(z') in the basic mode changes.

On the other hand, in the double lattice structure, when the spatial positional relationship of the main air hole 14K1 and the secondary air hole 14K2 changes, a diffraction intensity in the vertical direction also changes in the z-axis direction in the air-hole layer, that is, the ξ changes. In other words, the change in the position of the diffraction surface WS of the double lattice structure depends not only on the electric field profile Θ0(z') of Expression (3-4) but also on the ξ. Here, it will be clarified how the diffraction surface WS changes in the air-hole layer 14P in the z-axis direction when the spatial positional relationship between the main air hole 14K1 and the secondary air hole 14K2 changes.

### (2.2.1) Structure and Diffraction Surface of PCSEL element of Second Embodiment

For the PCSEL element 30 (see FIGS. 6A and 6B) of the second embodiment in which the air-hole layer 14P has a double lattice structure, the radiated wave radiated in the vertical direction is calculated in the same manner as in the case of the PCSEL element 10 (single lattice structure) of the first embodiment.

In the same manner as in the case of the first embodiment, the calculation is performed with the air hole period PC of 176 nm. In addition, the main air hole 14K1 is assumed to be a long hexagonal column having the air hole filling ratio FF1 of 10.1% and a long diameter/short diameter ratio of 1.74. The secondary air hole 14K2 is assumed to be a regular hexagonal column having the air hole filling ratio FF2 of 3.8% and a long diameter/short diameter ratio of 1.15. In addition, the centroid in-between distances of the main air hole 14K1 and the secondary air hole 14K2 are separated by 0.45 PC in both the x-axis direction (= Δx) and the y-axis direction (= Δy).

In addition, here, air hole depths of the main air hole 14K1 and the secondary air hole 14K2 are different from each other. FIG. 13 is a cross-sectional view schematically illustrating disposition of the main air hole 14K1 and the secondary air hole 14K2 in the depth direction. The lower end of the main air hole 14K1 is positioned deeper than the lower end of the secondary air hole 14K2, that is, in the -z direction. A depth h_{K1} (= d_{PC} ) of the main air hole 14K1 is 90 nm, and a depth h_{K2} of the secondary air hole 14K2 is 45 nm. In addition, the calculation is performed assuming that the upper end of the secondary air hole 14K2 is deeper than the upper end of the main air hole 14K1, the difference h_{UP} thereof is 5 nm, and the difference h_{DOWN} of the lower ends of the main air hole 14K1 and the secondary air hole 14K2 is 40 nm.

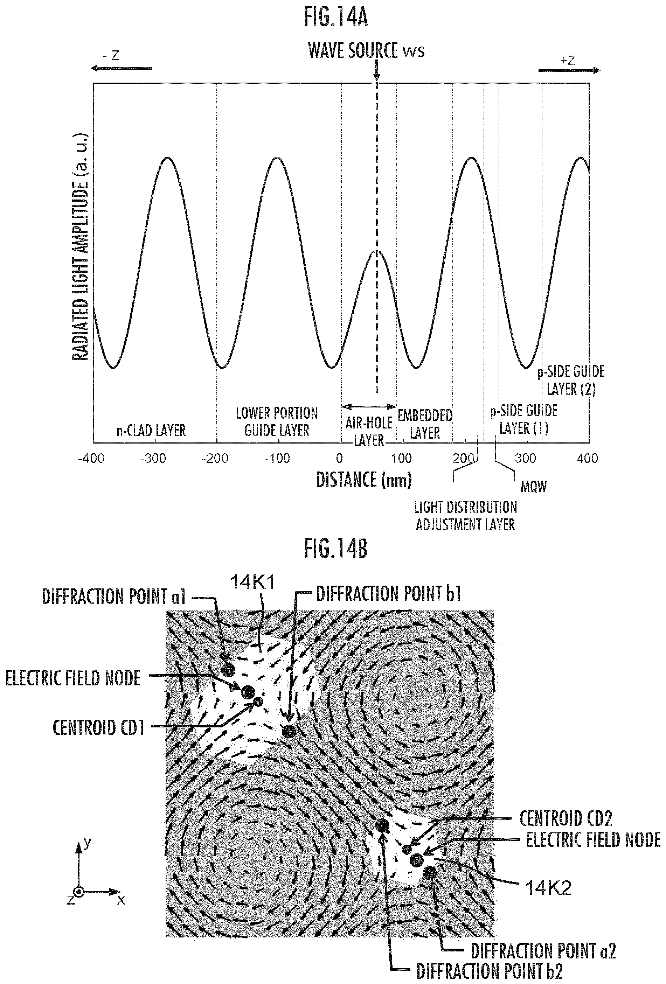

At this time, FIG. 14A illustrates an electric field amplitude of a radiated wave that is radiated in the vertical direction (z-axis direction) after light propagating in the air-hole layer 14P in the x-axis direction is diffracted at the air hole pair 14K. Although the air-hole layer 14P has a double lattice structure, an aspect can be seen that a radiated wave is radiated symmetrically in the +z direction and the -z direction with a certain point in the air-hole layer 14P as a starting point, that is, with the diffraction surface (wave source) WS as the starting point (symmetrical center surface).

In FIG. 14A, the diffraction surface WS is present about 8 nm from the center of the air-hole layer 14P in the +z-axis direction, that is, at a position close to the active layer 15. The diffraction surface WS is present approximately at a position about 4.5 nm in +z-axis direction from a z-direction center of the air-hole layer 14P as illustrated in FIG. 11 in the single lattice structure, but, in the case of the double lattice structure, is present more in the +z-axis direction than the above. This is due to structural factors such as the size, the depth, and the air hole shape of the main air hole 14K1 and the secondary air hole 14K2.

FIG. 14B illustrates an electric field distribution of light propagating in the air-hole layer 14P in the xy-plane around the main air hole 14K1 and the secondary air hole 14K2. Since the centroid in-between distances are shifted by 0.45 PC in the x-axis and y-axis directions, a node of the in-plane distribution of the propagating light is present at a position slightly shifted from the centroid positions CD1 and CD2 of the air holes of both the main air hole 14K1 and the secondary air hole 14K2. Therefore, the electric field strengths of the propagating light at target diffraction points a1 and b1 in the main air hole 14K1 are different, and the light diffracted at the respective points is radiated in the z-axis direction without completely canceling each other.

As illustrated in FIG. 13, although there are the region (regions of h_{UP} and h_{DOWN}) in which only the main air hole 14K1 is present in the depth direction (-z direction) and the region (region of h_{K2}) in which both the main air hole 14K1 and the secondary air hole 14K2 are present, for the propagating light component ξ (see Expression (3-4-2)) diffracted in the vertical direction, the region in which both the main air hole 14K1 and the secondary air hole 14K2 are present is biased more in the +z direction than a center C_{PC} of the air-hole layer 14P.

That is, the center C_{PC} (= C_{K2}) of the secondary air hole 14K2 in the depth direction (-z direction) is positioned closer to the side of the active layer 15 than a position of the center C_{K1} of the main air hole 14K1.

For the propagating light component ξ that is diffracted, the region in which both the main air hole 14K1 and the secondary air hole 14K2 are present is large. Therefore, it is considered that the diffraction surface WS is also present at a position shifted more in the +z direction than the center C_{PC} of the air-hole layer 14P.

### (2.2.2) h_{K2} Dependence of Diffraction Surface Position

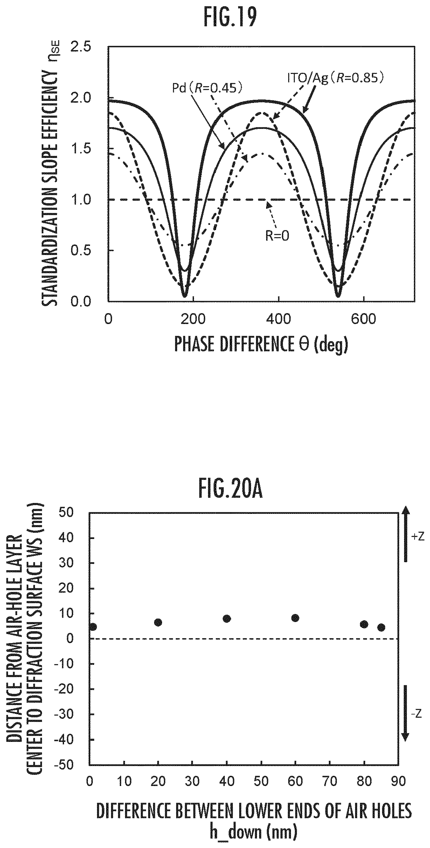

FIG. 20A illustrates a position of the diffraction surface WS with respect to the difference h_{DOWN} (see FIG. 13) of the lower ends of the main air hole 14K1 and the secondary air hole 14K2 when the difference h_{UP} of upper ends of the main air hole 14K1 and the secondary air hole 14K2 is constant. The calculation is performed assuming that the depth h_{K1} of the main air hole 14K1 is constant at 90 nm, the difference h_{UP} of the upper ends of the main air hole 14K1 and the secondary air hole 14K2 is constant at 5 nm, and the h_{DOWN} is changed from 1 nm to 85 nm. That is, the calculation is performed by changing the depth h_{K2} of the secondary air hole 14K2 from 84 nm to 0 nm.

As the h_{DOWN} increases, the position of the diffraction surface WS is shifted from the center C_{PC} of the air-hole layer 14P in the z-axis direction to the +z-axis direction, and is shifted to the most +z-axis direction, that is, to the side of the active layer when the h_{DOWN} is 60 nm. This is because the region (region of the h_{K2}) in which both the main air hole 14K1 and the secondary air hole 14K2 are present is biased in the +z-axis direction.

However, when the h_{DOWN} is 60 nm or more, the diffraction surface WS is shifted to approach the C_{PC}. This is because, when the h_{DOWN} increases, that is, when the depth h_{K2} of the secondary air hole 14K2 decreases, the effect of the double lattice structure cannot be obtained, and approaches the characteristics of the single lattice structure. Therefore, when the h_{DOWN} is 85 nm as the h_{K2} is to be 0 nm, the diffraction surface WS is present at a position shifted by 4.5 nm in the +z-axis direction from the center C_{PC} of the air-hole layer 14P, which is the same as the single lattice structure.

### (2.2.3) h_{DOWN} Dependence of Diffraction Surface Position

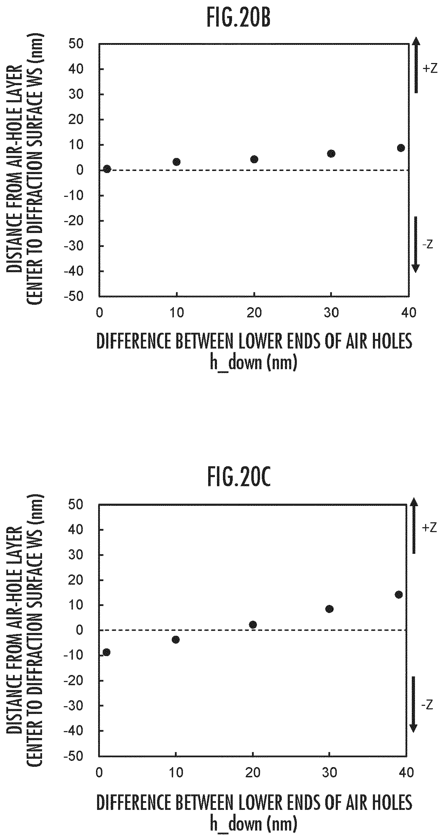

FIG. 20B illustrates a position of the diffraction surface WS with respect to the difference h_{DOWN} (see FIG. 13) of the lower ends of the main air hole 14K1 and the secondary air hole 14K2 when the depth h_{K2} of the secondary air hole 14K2 is constant. The depth h_{K1} of the main air hole 14K1 is 90 nm, the depth h_{K2} of the secondary air hole 14K2 is 50 nm, which is constant, and the h_{DOWN} is changed from 1 nm to 39 nm to perform calculation. At this time, the difference h_{UP} at the upper ends of the main air hole 14K2 and the secondary air hole 14K2 changes from 39 nm to 1 nm according to a change in hDowN.

When the h_{DOWN} is 1 nm, that is, when the positions of the lower ends of the main air hole 14K2 and the secondary air hole 14K2 are almost aligned, the diffraction surface WS is almost present at the center C_{PC} of the air-hole layer 14P in the z-axis direction. As the h_{DOWN} increases, the position of the diffraction surface WS moves in the +z-axis direction, that is, substantially linearly toward the active layer. This is because the region in which both the main air hole 14K1 and the secondary air hole 14K2 are present is biased in the +z-axis direction. Here, since the depth h_{K2} of the secondary air hole 14K2 is constant, the position of the diffraction surface WS with respect to the h_{DOWN} is monotonically shifted to the +z-axis direction. According to FIG. 20B, in the case of the relationship of FF1 > FF2 in FIG. 13, the diffraction surface WS is present at a position that is 0 to 10 nm away from the center of the air-hole layer 14P in the z-axis direction to the side of the active layer 15.

Subsequently, calculation is performed in a case where the air hole filling ratio FF1 of the main air hole 14K1 is 3.8% and the air hole filling ratio FF2 of the secondary air hole 14K2 is 10.1%, that is, a case where FF1 < FF2. FIG. 20C illustrates a position of the diffraction surface WS with respect to the difference h_{DOWN} (see FIG. 13) of the lower ends of the main air hole 14K1 and the secondary air hole 14K2 when the depth h_{K2} of the secondary air hole 14K2 is constant.

The position of the diffraction surface WS is monotonically shifted in the +z-axis direction as the h_{DOWN} increases, which is the same as in the case of FF1 > FF2, but the shift amount of the diffraction surface WS increases as compared with FIG. 20B. When the h_{DOWN} is 15 nm or less, the position of the diffraction surface WS is shifted more in the -z-axis direction than the center C_{PC} of the air-hole layer 14P in the z-axis direction. As illustrated in FIG. 14B, in a case where the air hole filling ratio is large, a region area in which the electric field of the light propagating in the air-hole layer 14P is distributed increases. That is, a case where the air hole filling ratio is large contributes more strongly to the diffraction, and the ξ of in Expression (3-4) increases. Therefore, in the case of FF1 < FF2, the position of the diffraction surface WS changes more greatly with respect to a bias (that is, a change in the h_{DOWN}) of the region in which both the main air hole 14K1 and the secondary air hole 14K2 in the air-hole layer 14P are present. According to FIG. 20C, in the case of the relationship of FF 1 < FF2 in FIG. 13, the diffraction surface WS is present at a position that is 10 to 15 nm away from the center of the air-hole layer 14P in the z-axis direction to the side of the active layer 15.

### (2.2.4) Centroid In-between Distance Dependence of Main Air Hole and Secondary Air Hole of Diffraction Surface Position

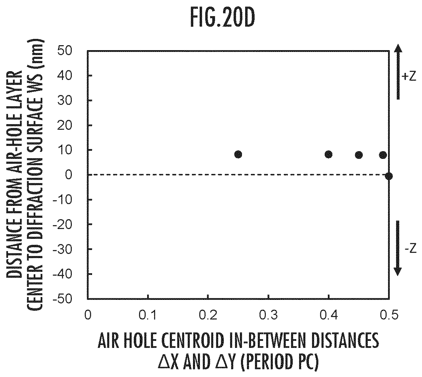

FIG. 20D illustrates a position of the diffraction surface WS when the centroid in-between distances Δx and Δy of the main air hole 14K1 and the secondary air hole 14K2 in x-axis and y-axis directions are changed from 0.25 PC to 0.5 PC by setting Δx = Δy. The calculation is performed assuming that the depth h_{K1} of the main air hole 14K1 is constant at 90 nm, the difference h_{UP} of the upper ends of the main air hole 14K1 and the secondary air hole 14K2 is constant at 5 nm, and the h_{DOWN} is changed from 1 nm to 85 nm. That is, the calculation is performed by changing the depth h_{K2} of the secondary air hole 14K2 from 84 nm to 0 nm.

In a case where the centroid in-between distances Δx and Δy are in the range of 0.25 PC to 0.49 PC, the position of the diffraction surface WS does not change, and is present in a position biased by 8 nm in the +z-axis direction from the center C_{PC} of the air-hole layer 14P in the z-axis direction. In a case where the Δx and the Δy are 0.50 PCs, the diffraction surface WS is almost at the same position as the Crc. This is because, in a case where the centroid in-between distances Δx and Δy are 0.5 PCs, the effect that the light propagating in the air-hole layer 14P is diffracted by the air hole is to be the same as the effect in the case of the single lattice structure since the rotational symmetry of the structure of the photonic crystal is high.

From the above, in the case of the double lattice structure, it can be understood that the position of the diffraction surface strongly depends on the difference h_{DOWN} of the lower ends of the main air hole 14K1 and the secondary air hole 14K2, that is, a change in a bias of the region, in which both the main air hole 14K1 and the secondary air hole 14K2 in the air-hole layer 14P are present, in the z-axis direction in the air-hole layer 14P. In addition, in FIG. 13, when the air hole filling ratio FF 1 is smaller than the air hole filling ratio FF2 of the secondary air hole 14K2 (FF1 < FF2), in a case where the region, in which both the main air hole 14K1 and the secondary air hole 14K2 in the air-hole layer 14P are present, is biased more in the -z-axis direction in the air-hole layer 14P than the center C_{PC} of the air-hole layer in the z-axis direction, it can be seen that the diffraction surface WS is present at a position shifted more in the -z-axis direction than the center Crc.

### (3) Diffraction Surface Position of Nitride-Based PCSEL Element

### (3.1) Case of Single Lattice Structure

In the group 3 nitride-based PCSEL element, due to the front surface reconfiguration by mass transport during the embedment growth, the air hole has a hexagonal columnar structure whose side surfaces are configured with the m-plane. That is, a structure in which the air hole filling ratio FF hardly changes in the z-axis direction is provided.

For this reason, the diffraction surface WS is present at a position biased in the +z-axis direction from the center C_{PC} (that is, the center in the depth direction of the air hole) of the air-hole layer 14P in the z-axis direction. The bias in the +z-axis direction remarkably increases as the air-hole layer thickness is thickened, but from the viewpoint of emission efficiency, the thickness of the air-hole layer 14P is preferably thinner than the length for one wavelength. Therefore, the diffraction surface WS is present at a position that is in the range of 0 to 51 nm away from the center C_{PC} of the air-hole layer 14P in the z-axis direction to the side of the active layer 15. The wavelength of use may be other than blue light, the thickness of the air-hole layer 14P is adjusted to a desired wavelength of use, and the change in the diffraction surface WS strongly depends on the air-hole layer thickness as illustrated in FIG. 12A.

In the first embodiment, the position of the diffraction surface WS of the air-hole layer 14P estimated by the calculation using the coupled wave theory is estimated to be present 1.5 nm to the side of the active layer 15 (that is, +z-axis direction) from the center C_{PC} of the air-hole layer 14P. This numerical value and the layer thickness of each layer including each layer are added together, and the separation distance dr from the reflection surface Sr to the diffraction surface WS is estimated to be 1073.5 nm.

### (3.2) Case of Double Lattice Structure

Even in the PCSEL element having the double lattice structure, the diffraction surface WS is basically present at a position biased from the center of the air-hole layer 14P in the z-axis direction to the side of the active layer 15 (+z-axis direction). Note that, when the air hole filling ratio FF1 of the main air hole 14K1 is smaller than the air hole filling ratio FF2 of the secondary air hole 14K2 (FF1 < FF2), the diffraction surface WS is present a position biased more to the side of the clad layer (-z-axis direction) than the center C_{PC} of the air-hole layer 14P in the z-axis direction.

Note that, in the nitride-based PCSEL element, when holes having different sizes are simultaneously formed by the dry etching method and the holes are embedded to form the air holes 14K1 and 14K2, the holes with large openings have faster etching rates and are deepened. Therefore, in the air-hole layer 14P of the nitride-based PCSEL element, when the opening portion of the main hole 14H1 is larger than that of the secondary hole 14H2, the 14H1 is deepened.

As described above, the main hole 14H1 and the secondary hole 14H2 are embedded by forming the {1-101} on the front surface of the hole, and are to be the main air hole 14K1 and the secondary air hole 14K2, respectively. At this time, since the positional relationship of the bottom surfaces of the respective holes to be embedded does not change, the lower end of the main air hole 14K1 is positioned more in the -z-axis direction than the lower end of the secondary air hole 14K2. The main air hole 14K1 is formed at a position deeper than the secondary air hole 14K2.

In addition, as described above, since the shapes of the main air hole 14K1 and the secondary air hole 14K2 formed by being embedded have a hexagonal columnar structure whose side surfaces have the m-plane, the size relationship of the main air hole 14K1 and the secondary air hole 14K2 is the same as the size relationship of the holes before the embedment.

From the above, in a case where the active layer 15 is formed after the air-hole layer 14P is formed, that is, in a case where the air-hole layer 14P is provided on the side of the -z-axis direction of the active layer 15, when the air hole filling ratio FF1 of the main air hole 14K1 is larger than the air hole filling ratio FF2 of the secondary air hole 14K2 (FF1 > FF2), the lower end of the main air hole 14K1 is always positioned more on the side of the -z-axis direction than the lower end of the secondary air hole 14K2. That is, in a case of the relationship of FF1 > FF2, the lower end of the air-hole layer 14P matches the lower end of the main air hole 14K1.

That is, in the group 3 nitride-based PCSEL element, even in the case of the double lattice structure, the wave source (diffraction surface) WS is always present at a position that is about 0 to 10 nm away from the center C_{PC} (that is, the center of the main air hole 14K1) of the air-hole layer 14P in the z-direction to the side of the active layer 15. In a case of the relationship of FF1 < FF2, the lower end of the air-hole layer 14P and the lower end of the main air hole 14K1 do not match (that is, the lower end of the air-hole layer 14P and the lower end of the secondary air hole 14K2 match), so that the diffraction surface WS as in FIG. 20C is not positioned more in a direction opposite to the active layer 15, that is, on the side of the -z direction than the center C_{PC} of the air-hole layer 14P in the z-direction.

In the second embodiment, the position of the diffraction surface WS of the air-hole layer 14P estimated by the calculation using the coupled wave theory is estimated to be present 7.3 nm to the side of the active layer 15 (that is, +z-axis direction) from the center C_{PC} of the air-hole layer 14P. This numerical value and the layer thickness of each layer including ITO layer are added together, and the separation distance dr from the reflection surface Sr to the diffraction surface WS is estimated to be 920.7 nm.

In the second embodiment, the air hole has been described in which the air hole has a hexagonal columnar shape and the cross-sectional area does not change in the depth direction. When either the main air hole 14K1 or the secondary air hole 14K2 has a shape in which the cross-sectional area changes in the depth direction, it is preferable that the centroid of the secondary air hole 14K2 is positioned more to the side of the active layer 15 than the centroid of the main air hole 14K1.

In addition, in the double lattice structure, the position of the diffraction surface WS in the air-hole layer 14P strongly depends on a bias of the region, in which both the main air hole 14K1 and the secondary air hole 14K2 are present, in the z-axis direction. That is, in order to stabilize the position of the diffraction surface WS, it is preferable to improve the controllability of the positional relationship between the main air hole 14K1 and the secondary air hole 14K2. In the present invention, embedment of the air hole is performed by growing the {1-101} facet surface on the front surface. Since this method can reduce the change in the air hole shape due to the mass transport, it is easy to control the position of each air hole, and this method is a manufacturing method suitable for stabilizing the position of the diffraction surface WS.

### (3.3) Reason for Disposing Air-hole Layer on n Side of in Group 3 Nitride-based PCSEL Element

In Embodiments 1 and 2 described above, the air-hole layer 14P is disposed closer to the side of an n-layer than the active layer 15. Although the air-hole layer 14P is disposed on the p side, when a distance from the active layer 15 is sufficiently short, a resonance effect due to the photonic crystal can be obtained and laser oscillation is possible.

However, in the group 3 nitride-based material, Mg is generally used as a p-type dopant, but the doped Mg forms an intermediate level in a bandgap and causes light absorption.

In the PCSEL element, in order to obtain a high resonance effect due to the photonic crystal, it is preferable to distribute (confine) a larger amount of the electric field in a waveguide mode to the air-hole layer 14P. However, in a case where the air-hole layer 14P is a p-type, the absorption of the semiconductor is increased when a large amount of the electric field is distributed in the air-hole layer 14P, as compared with a case where the air-hole layer 14P is an n-type. That is, the internal loss αi in Expression (2-4) increases, and the emission efficiency decreases.

In addition, when the air-hole layer 14P is disposed on the p side, it is also considered that light absorption in the air-hole layer is reduced by making the air-hole layer 14P an undoped layer. However, when a large amount of the electric field in the waveguide mode is distributed to the air-hole layer 14P, the electric field distribution is to be a distribution biased to the side of the air-hole layer 14P, and as a result, a large amount of the electric field is distributed also to the p-type layer doped with Mg. Therefore, although the air-hole layer 14P is made into an undoped layer, the internal loss αi increases and the emission efficiency decreases.

Therefore, in order to obtain higher emission efficiency in the group 3 nitride-based PCSEL element, it is preferable to dispose the air-hole layer 14P on the side of the n-layer.

### <Result and Consideration>

### (1) Characteristics of First embodiment

### (1.1) Emission Efficiency

Using the two-dimensional coupled wave theory, the resonator loss αp in the in-plane direction and the resonator loss αn in the vertical direction of the air-hole layer 14P in the PCSEL element of the single lattice structure of the first embodiment are estimated. In addition, a light confinement coefficient Γmg of an Mg-doped layer is calculated from the electric field strength distribution in the basic mode, and the internal loss αi is estimated. The results are illustrated in the following Table 1.

**[Table 1]**

| Table 1: Optical Loss (First Embodiment) | | |
|---|---|---|
| αn (α⊥) | αₚ (α_{//}*)* | αi |
| 2.5 | 6.5 | 6.0 |

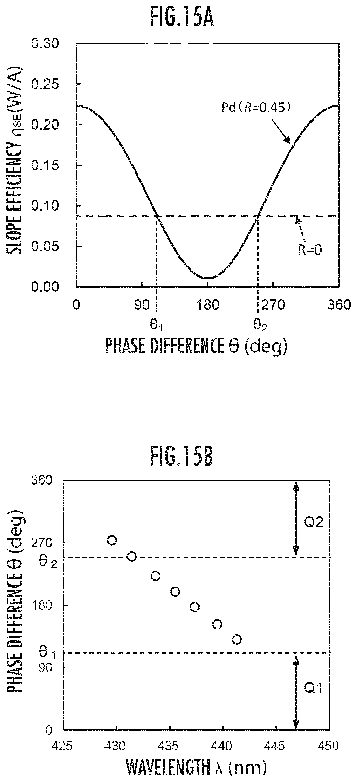

In the first embodiment, since Pd is adopted as the p-electrode, the reflectivity R of the reflection surface Sr is about 0.45. FIG. 15A illustrates a result of calculating the possible slope efficiency ηSE with respect to the phase difference θ (deg) between the direct diffracted light Ld and the reflected diffracted light Lr on the diffraction surface WS (wave source) using Expression (2-4). For comparison, FIG. 15A also plots a case where the reflection surface Sr is not present and the reflected diffracted light Lr does not contribute to emission (R = 0: broken line).

At this time, when the phase difference θ at which the slope efficiencies ηSE in a case of considering the reflection surface Sr and a case of not considering the reflection surface Sr intersect each other is set as θ1 and θ2, the range of the phase difference θ in which the improvement of the slope efficiency ηSE by the reflection surface Sr is expected, is as follows. In the first embodiment, θ1 = 111.1° and θ2 = 248.9°.
Range Q1: $0 ° \leq θ < θ 1$ or
Range Q2: $θ 2 < θ \leq 360 °$

### (1.2) Relationship of Phase Difference with respect to Oscillation Wavelength

In the first embodiment, the photonic crystal in which the period PC of the air hole 14K is changed from 173 to 179 nm is manufactured on the same substrate. That is, in the device having the same separation distance dr (distance between the diffraction surface WS and the reflection surface SR), the oscillation wavelength λ is changed from 430 to 441 nm. The phase difference θ between the direct diffracted light Ld and the reflected diffracted light Lr, assuming that the wave number of the emitted light is k and the optical path length is x, is$kx = \frac{2 π}{λ} 2 {n}_{ave} dr = \left(\frac{θ}{360 °}2π+π+2mπ\right)$ (4-1) , so that the phase difference θ with respect to the oscillation wavelength changes as described in the following expression.$\frac{θ}{360 °} = \frac{2 {n}_{ave} dr}{λ} - \left(m+\frac{1}{2}\right)$ (4-2)

In addition, the separation distance dr is represented by the following expression.$d r = \left(\frac{θ}{360 °}+0.5+m\right) \frac{λ}{2 {n}_{ave}}$ (4-3)

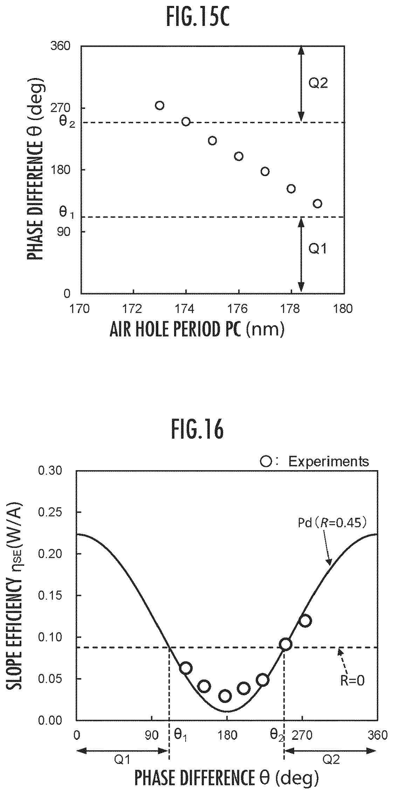

Therefore, in the first embodiment, the phase difference θ can be changed while the separation distance dr, which is the distance between the diffraction surface and the reflection surface, is constant, and the effect of interference between the direct diffracted light Ld and the reflected diffracted light Lr can be confirmed. FIG. 15B illustrates the phase difference θ with respect to the wavelength λ obtained from Expression (4-2). In addition, FIG. 15C illustrates the phase difference θ with respect to the air hole period PC at this time.

When the wavelength λ is 430 nm or 431.5 nm, that is, when PC = 171 and 172 nm, the direct diffracted light Ld and the reflected diffracted light Lr strengthen each other, and the slope efficiency ηSE and the light intensity (light output) of the combined light are improved.

From Expression (2-4), the slope efficiency ηSE (0) in a case where there is no reflection by the reflection surface is given by the following expression. ${η}_{SE} \left(0\right) = \frac{hν}{e} {η}_{i} \frac{\frac{1}{2} {α}_{⊥}}{{α}_{⊥} + {α}_{/ /} + {α}_{i}}$ (5-1)

In the case where there is reflection (the reflectivity R), in order to increase the slope efficiency as compared with the case where there is no reflection, when ηSE (R) > ηSE (0) is satisfied, the following expression is obtained.$\frac{\left(1+2\sqrt{R} cos θ+R\right) {α}_{⊥}}{\left(1+\sqrt{R} cos θ\right) {α}_{⊥} + {α}_{∥} + {α}_{i}} > \frac{{α}_{⊥}}{{α}_{⊥} + {α}_{∥} + {α}_{i}}$ (5-2)

Therefore, in order to satisfy ηSE (R) > ηSE (0), the phase difference θ is given by the following expression.$cos θ > - \frac{\sqrt{R} \left({α}_{⊥}+{α}_{/ /}+{α}_{i}\right)}{{α}_{⊥} + 2 \left({α}_{/ /}+{α}_{i}\right)}$ (5-3)

### (1.3) Experimental Result

The improvement effect of the slope efficiency ηSE is verified by an experiment. FIG. 16 is a diagram in which the slope efficiency ηSE obtained by an experiment is plotted (marked as a circle) with respect to the phase difference θ estimated from Expression (4-2). A calculation result (solid line) of the slope efficiency ηSE illustrated in FIG. 15A is also illustrated.

It can be seen that the experimental results that are in good agreement with the calculation results are obtained. In addition, with respect to the ranges Q1 and Q2 of the phase difference θ, the improvement of the slope efficiency ηSE can be confirmed. Accordingly, it is important that the phase difference θ is present in the range Q1 or Q2 in order to increase the slope efficiency ηSE, and it is confirmed that the PCSEL element having the separation distance dr satisfying the phase difference θ increases the slope efficiency ηSE and effectively obtains a high light output.

### (2) Characteristics of Second Embodiment

### (2.1) Emission Efficiency

In the same manner as in the case of the first embodiment, the resonator loss αp in the in-plane direction and the resonator loss αn in the vertical direction of the air-hole layer 14P in the PCSEL element of the double lattice structure of the second embodiment are estimated. The results are illustrated in the following Table 2.

**[Table 2]**

| Table 2: Optical Loss (Second Embodiment) | | |
|---|---|---|
| αn (α⊥) | αₚ (α_{//}) | αi |
| 5.0 | 7.0 | 4.7 |

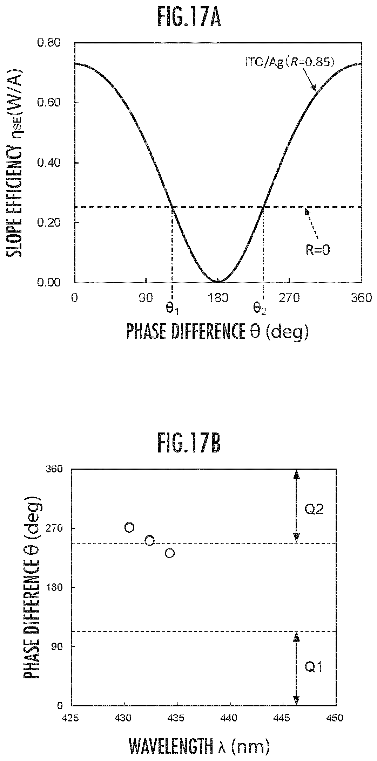

In the second embodiment, since ITO/Ag is adopted as the p-electrode, the reflectivity R of the reflection surface Sr is about 0.85, which is higher than the reflectivity in the first embodiment. FIG. 17A illustrates a result of calculating the possible slope efficiency ηSE with respect to the phase difference θ (deg) between the direct diffracted light Ld and the reflected diffracted light Lr using Expression (2-4). For comparison, FIG. 17A also plots a case where the reflection surface Sr is not present and the reflected diffracted light Lr does not contribute to emission (R = 0: broken line).

At this time, when the phase difference θ at which the slope efficiencies ηSE in a case of considering the reflection surface Sr and a case of not considering the reflection surface Sr intersect each other is set as θ1 and θ2, the range of the phase difference θ in which the improvement of the slope efficiency ηSE by the reflection surface Sr is expected, is as follows. In the second embodiment, θ1 = 113.2° and θ2 = 246.8°. From this, it can be seen that the range Q1 and the range Q2 that are allowable grow to be wider as the reflectivity R of the reflection surface Sr increases.

### (2.2) Relationship of Phase Difference with respect to Oscillation Wavelength

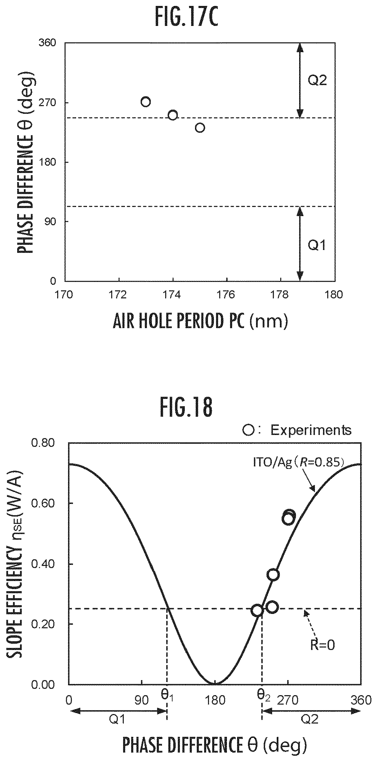

In the second embodiment, the photonic crystal in which the period PC of the air hole pair 14K is changed from 173 to 175 nm is manufactured on the same substrate. FIG. 17B illustrates the phase difference θ with respect to the wavelength λ obtained from Expression (4-2). In addition, FIG. 17C illustrates the phase difference θ with respect to the air hole period PC at this time. When the wavelength λ is 430 nm or 432 nm, that is, when PC = 171 and 172 nm, it is estimated that the direct diffracted light Ld and the reflected diffracted light Lr strengthen each other and the slope efficiency ηSE is improved.

### (2.3) Experimental Result

The improvement effect of the slope efficiency ηSE is verified by an experiment. FIG. 18 is a diagram in which the slope efficiency ηSE obtained by an experiment is plotted (marked as a circle) with respect to the phase difference θ estimated from Expression (4-2). A calculation result (solid line) of the slope efficiency ηSE illustrated in FIG. 17A is also illustrated.

It can be seen that the experimental results that are in good agreement with the calculation results are obtained. In addition, with respect to the ranges Q1 or Q2 of the phase difference θ, the improvement of the slope efficiency ηSE can be confirmed. Therefore, in order to increase the slope efficiency ηSE, it is important that the phase difference θ is present in the range Q1 or Q2 described above, that is, by having the separation distance dr that satisfies the phase difference θ between the direct diffracted light Ld and the reflected diffracted light Lr, it is confirmed that the slope efficiency ηSE and the light intensity of the combined light can be improved and the PCSEL element with high efficiency and high light output can be provided.

### <Difference from Simple Interference between Direct Diffracted Light and Reflected Diffracted Light>

The change in the slope efficiency ηSE with respect to the phase difference θ in the present invention is different from the case where the direct diffracted light Ld and the reflected diffracted light Lr simply interfere with each other.

More specifically, the slope efficiency ηSE in a case of only considering that the direct diffracted light Ld emitted in the -z direction (emission direction) and the reflected diffracted light Lr emitted in the +z direction and reflected by the electrode to be emitted in the -z direction interfere with each other, is represented by the following expression.${η}_{SE} = \frac{hν}{e} {η}_{i} \frac{{α}_{⊥}}{{α}_{⊥} + {α}_{/ /} + {α}_{i}} \left(0.5+0.5R cos θ\right)$ (6)

FIG. 19 illustrates the dependence of the slope efficiency ηSE with respect to the phase difference θ obtained from Expression (6) above in an ideal state (the injection efficiency ηi = 0, the reflectivity R = 0, and the internal loss αi = 0 during a laser oscillation operation). In addition, the slope efficiencies ηSE in a case where the electrode materials of FIG. 10 are Pd and ITO/Ag are illustrated by the thick solid line and the thin solid line, respectively. That is, FIG. 19 illustrates a graph of the dependence of the slope efficiency ηSE with respect to the phase difference θ obtained by Expression (6) above, superimposed on the graph of FIG. 10.

In a case where only the interference between the direct diffracted light Ld and the reflected diffracted light Lr is considered, regardless of the reflectivity of the electrode material, in a case of 0° ≤ θ < 90°, 270° < θ ≤ 360°, it can be seen that the slope efficiency is higher than in a case where there is no the reflection electrode (R = 0). Pd (R = 0.45: single-dot chain line) and ITO/Ag (R = 0.85: broken line) are illustrated as electrode materials.

When the emitted light is weakened by the interference between the direct diffracted light Ld and the reflected diffracted light Lr, it means that the radiation loss (loss in the vertical direction) αn is reduced. That is, although the radiation loss αn is constant in Expression (5), it is necessary to obtain the slope efficiency ηSE in consideration of the influence of interference on the radiation loss αn. Specifically, the slope efficiency ηSE in the PCSEL element is given by Expression (2-4).

As illustrated in FIG. 19, the range of the phase difference θ at which a high slope efficiency is obtained is wider than in a case where only the interference between the direct diffracted light Ld and the reflected diffracted light Lr is considered, and depends on the rear surface reflectivity (electrode material). The slope efficiencies ηSE in a case where the electrode materials are Pd and ITO/Ag are illustrated by the thick solid line and the thin solid line, respectively.

The numerical values in the above-described embodiments are merely examples, and can be appropriately modified and applied. In addition, the PCSEL elements having a single lattice structure and a double lattice structure have been exemplified, but can be generally applied to the PCSEL elements having a multi-lattice structure.

In addition, the present invention exemplifies the air-hole layer in which the air hole has a hexagonal columnar shape, but also can be applied to a case where the air hole has a columnar shape, a rectangular shape, a polygonal shape, or an irregular columnar shape such as a teardrop shape.

As described in detail above, according to the present embodiment described above, by specifying an interference condition between the diffracted light and the reflected diffracted light by a reflection mirror, it is possible to provide a high-performing photonic-crystal surface-emitting laser that has high emission efficiency and operates in a low threshold value current density and high efficiency.

## Claims

1. A surface-emitting laser element (10, 30) comprising:
a translucent substrate (12);
a first semiconductor layer (13, 14, 23) that is provided on the substrate (12);
an active layer (15) that is provided on the first semiconductor layer (13, 14, 23);
a second semiconductor layer (16, 17, 18, 19) that is provided on the active layer (15) and is of an opposite conductive type from the first semiconductor layer (13, 14, 23);
an air-hole layer (14P) that is a photonic crystal layer included in the first semiconductor layer (14) and including an air hole (14K, 14K1, 14K2) disposed with a two-dimensional periodicity in a plane parallel to the active layer (15); and
a reflection layer (20B) that is provided on the second semiconductor layer (16, 17, 18, 19) and has a reflection surface (SR),
wherein a light emission surface is provided on a rear surface (12R) of the substrate (12),
wherein the air-hole layer (14P) provides a diffraction surface (WS) that is positioned closer to the active layer (15) than a center of the air-hole layer (14P) in a depth direction ,
wherein a separation distance (dr) between the diffraction surface (WS) and the reflection surface (SR) is provided such that a light intensity of combined light of first diffracted light (Ld) diffracted from the diffraction surface (WS) to a side of the light emission surface and second diffracted light (Lr) diffracted from the diffraction surface (WS) to a side of the reflection layer and reflected on the reflection surface (SR) is larger than a light intensity of the first diffracted light (Ld),
wherein the separation distance (dr) is a phase difference between the first diffracted light (Ld) diffracted by the diffraction surface (WS) and the second diffracted light (Lr) diffracted by the diffraction surface (WS) and reflected by the reflection surface (SR), and when the phase difference is set as θ, a wavelength of the first diffracted light (Ld) is set as λ, an average refractive index of a crystal layer from the diffraction surface (WS) to the reflection surface (SR) is set as nₐᵥₑ, and an integer of 0 or more is set as m, the separation distance (dr) is represented by the following expression: $d r = \left(\frac{θ}{360 °}+0.5+m\right) \frac{λ}{2 {n}_{ave}}$ and
when a reflectivity of the reflection surface (SR) is set as R, losses of the air-hole layer (14P) in an in-plane direction and a vertical direction of the air-hole layer (14P) are set as αn and αp, respectively, and an internal loss is set as αi, the phase difference θ satisfies: $cos θ > - \frac{\sqrt{R} \left({α}_{n}+{α}_{p}+{α}_{i}\right)}{{a}_{n} + 2 \left({α}_{p}+{α}_{i}\right)}$

2. The surface-emitting laser element (10, 30) according to claim 1, wherein
an anti-reflection film (27) is provided on the light emission surface of the substrate (12).

3. The surface-emitting laser element (10, 30) according to claim 1 or 2, wherein
the first semiconductor layer (13, 14, 23), the active layer (15), and the second semiconductor layer (16, 17, 18, 19) are group 3 nitride-based semiconductor layers, and the first semiconductor layer (13, 14, 23) and the second semiconductor layer (16, 17, 18, 19) are an n-type semiconductor layer and a p-type semiconductor layer, respectively.

4. The surface-emitting laser element (30) according to any one of claims 1 to 3, wherein
the second semiconductor layer (16, 17, 18, 19) is a p-type semiconductor layer, and a translucent conductor film (25) is provided between the reflection surface (SR) and the p-type semiconductor layer (16, 17, 18, 19).

5. The surface-emitting laser element (30) according to claim 4, wherein
the translucent conductor film (25) is an indium tin oxide, ITO, film, the reflection layer (SR) is a silver, Ag, film, and the separation distance (dr) satisfies $\frac{\left(0.5+m\right) λ}{2 {n}_{ave}} < dr < \frac{\left(0.921+m\right) λ}{2 {n}_{ave}} or , \frac{\left(1.079+m\right) λ}{2 {n}_{ave}} < dr < \frac{\left(1.5+m\right) λ}{2 {n}_{ave}} .$

6. The surface-emitting laser element (10, 30) according to any one of claims 1 to 3, wherein
the second semiconductor layer (16, 17, 18, 19) is a p-type semiconductor layer, a second electrode (20B) provided on the second semiconductor layer (16, 17, 18, 19) is palladium, Pd, and the separation distance (dr) satisfies $\frac{\left(0.5+m\right) λ}{2 {n}_{ave}} < dr < \frac{\left(0.861+m\right) λ}{2 {n}_{ave}} or , \frac{\left(1.139+m\right) λ}{2 {n}_{ave}} < dr < \frac{\left(1.5+m\right) λ}{2 {n}_{ave}} .$

7. The surface-emitting laser element (10, 30) according to any one of claims 1 to 6, wherein
the air-hole layer (14P) has a thickness (d_{PC}) of less than one wavelength of an optical path length of the air-hole layer (14P).

8. The surface-emitting laser element (10, 30) according to any one of claims 1 to 7, wherein
the air-hole layer (14P) is a photonic crystal layer having a double lattice structure in which a main air hole (14K1) and a secondary air hole (14K2) having an air hole diameter and a depth that are small as compared with the main air hole (14K1) are disposed at lattice points, and a centroid position (CD2) of the secondary air hole (14K2) in a depth direction is closer on a side of the active layer (15) than a centroid position (CD1) of the main air hole (14K1).

## Patentansprüche

1. Ein oberflächenemittierendes Laserelement (10, 30), aufweisend:
ein lichtdurchlässiges Substrat (12),
eine erste Halbleiterschicht (13, 14, 23), die auf dem Substrat (12) vorgesehen ist,
eine aktive Schicht (15), die auf der ersten Halbleiterschicht (13, 14, 23) vorgesehen ist,
eine zweite Halbleiterschicht (16, 17, 18, 19), die auf der aktiven Schicht (15) vorgesehen ist und von einem der ersten Halbleiterschicht (13, 14, 23) entgegengesetzten Leitungstyp ist,
eine Luftlochschicht (14P), die eine photonische Kristallschicht ist, die in der ersten Halbleiterschicht (14) enthalten ist und ein Luftloch (14K, 14K1, 14K2), das mit einer zweidimensionalen Periodizität in einer Ebene parallel zu der aktiven Schicht (15) angeordnet ist, enthält, und
eine Reflexionsschicht (20B), die in der zweiten Halbleiterschicht (16, 17, 18, 19) vorgesehen ist und eine Reflexionsfläche (SR) aufweist,
wobei eine Lichtemissionsfläche an einer Rückfläche (12R) des Substrats (12) vorgesehen ist,
wobei die Luftlochschicht (14P) eine Diffraktionsfläche (WS) vorsieht, die näher an der aktiven Schicht (15) angeordnet ist als eine Mitte der Luftlochschicht (14P) in einer Tiefenrichtung,
wobei eine Trennungsdistanz (dr) zwischen der Diffraktionsfläche (WS) und der Reflexionsfläche (SR) derart vorgesehen ist, dass die Lichtintensität des kombinierten Lichts eines ersten gebeugten Lichts (Ld), das von der Diffraktionsfläche (WS) zu der Seite der Lichtemissionsfläche gebeugt wird, und eines zweiten gebeugten Lichts (Lr), das von der Diffraktionsfläche (WS) zu der Seite der Reflexionsschicht gebeugt und an der Reflexionsfläche (SR) reflektiert wird, größer als die Lichtintensität des ersten gebeugten Lichts (Ld) ist,
wobei die Trennungsdistanz (dr) eine Phasendifferenz zwischen dem ersten gebeugten Licht (Ld), das durch die Diffraktionsfläche (WS) gebeugt wird, und dem zweiten gebeugten Licht (Lr), das durch die Diffraktionsfläche (WS) gebeugt und durch die Reflexionsfläche (SR) reflektiert wird, ist, wobei, wenn die Phasendifferenz als θ gesetzt ist, die Wellenlänge des ersten gebeugten Lichts (Ld) als λ gesetzt ist, der durchschnittliche Refraktionsindex einer Kristallschicht von der Diffraktionsfläche (WS) zu der Reflexionsfläche (SR) als nₐᵥₑ gesetzt ist und eine Ganzzahl von 0 oder größer als m gesetzt ist, die Trennungsdistanz (dr) durch den folgenden Ausdruck wiedergegeben wird: $d r = \left(\frac{0}{360 °}+0,5+m\right) \frac{λ}{2 {n}_{ave}}$ und wobei, wenn der Reflexionsgrad der Reflexionsfläche (SR) als R gesetzt ist, Verluste der Luftlochschicht (14P) in einer Ebenenrichtung und einer vertikalen Richtung der Luftlochschicht (14P) jeweils als αn und αp gesetzt sind und ein interner Verlust als αi gesetzt ist, die Phasendifferenz θ Folgendes erfüllt: $cos θ > - \frac{\sqrt{R} \left({α}_{n}+{α}_{p}+{α}_{i}\right)}{{α}_{n} + 2 \left({α}_{p}+{α}_{i}\right)}$

2. Oberflächenemittierendes Laserelement (10, 30) nach Anspruch 1, wobei ein Antireflexionsfilm (27) auf der Lichtemissionsfläche des Substrats (12) vorgesehen ist.

3. Oberflächenemittierendes Laserelement (10, 30) nach Anspruch 1 oder 2, wobei:
die erste Halbleiterschicht (13, 14, 23), die aktive Schicht (15) und die zweite Halbleiterschicht (16, 17, 18, 19) Gruppe 3-Nitrid-basierte Halbleiterschichten sind und die erste Halbleiterschicht (13, 14, 23) und die zweite Halbleiterschicht (16, 17, 18, 19) jeweils eine n-Typ-Halbleiterschicht und eine p-Typ-Halbleiterschicht sind.

4. Oberflächenemittierendes Laserelement (30) nach einem der Ansprüche 1 bis 3, wobei:
die zweite Halbleiterschicht (16, 17, 18, 19) eine p-Typ-Halbleiterschicht ist und ein lichtdurchlässiger Leiterfilm (25) zwischen der Reflexionsfläche (SR) und der p-Typ-Halbleiterschicht (16, 17, 18, 19) vorgesehen ist.

5. Oberflächenemittierendes Laserelement (30) nach Anspruch 4, wobei:
der lichtdurchlässige Leiterfilm (25) ein Indiumzinnoxid (ITO)-Film ist, wobei die Reflexionsfläche (SR) ein Silber (Ag)-Film ist und die Trennungsdistanz (dr) Folgendes erfüllt: $\frac{\left(0,5+m\right) λ}{2 {n}_{ave}} < dr < \frac{\left(0,921+m\right) λ}{2 {n}_{ave}} oder \frac{\left(1,079+m\right) λ}{2 {n}_{ave}} < dr < \frac{\left(1,5+m\right) λ}{2 {n}_{ave}}$

6. Oberflächenemittierendes Laserelement (10, 30) nach einem der Ansprüche 1 bis 3, wobei:
die zweite Halbleiterschicht (16, 17, 18, 19) eine p-Typ-Halbleiterschicht ist, eine zweite Elektrode (20B) auf der zweiten Halbleiterschicht (16, 17, 18, 19) aus Palladium (Pd) besteht und die Trennungsdistanz (dr) Folgendes erfüllt: $\frac{\left(0,5+m\right) λ}{2 {n}_{ave}} < dr < \frac{\left(0,861+m\right) λ}{2 {n}_{ave}} oder \frac{\left(1,139+m\right) λ}{2 {n}_{ave}} < dr < \frac{\left(1,5+m\right) λ}{2 {n}_{ave}}$

7. Oberflächenemittierendes Laserelement (10, 30) nach einem der Ansprüche 1 bis 6, wobei:
die Luftlochschicht (14P) eine Dicke (d_{PC}) von weniger als einer Wellenlänge einer Optikpfadlänge der Luftlochschicht (14P) aufweist.

8. Oberflächenemittierendes Laserelement (10, 30) nach einem der Ansprüche 1 bis 7, wobei:
die Luftlochschicht (14P) eine photonische Kristallschicht mit einer doppelten Gitterstruktur ist, in der ein primäres Luftloch (14K1) und ein sekundäres Luftloch (14K2), das einen Luftlochdurchmesser und eine Tiefe, die klein im Vergleich zu denjenigen des primären Luftlochs (14K1) sind, aufweist, an Gitterpunkten angeordnet sind, wobei eine Schwerpunktposition (CD2) des sekundären Luftlochs (14K2) in einer Tiefenrichtung näher auf einer Seite der aktiven Schicht (15) ist als eine Schwerpunktposition (CD1) des primären Luftlochs (14K1).

## Revendications

1. Élément laser à émission de surface (10, 30), comprenant :
un substrat translucide (12) ;
une première couche semiconductrice (13, 14, 23) qui est prévue sur le substrat (12) ;
une couche active (15) qui est prévue sur la première couche semiconductrice (13, 14, 23) ;
une deuxième couche semiconductrice (16, 17, 18, 19) qui est prévue sur la couche active (15) et qui est d'un type de conductivité opposé à celui de la première couche semiconductrice (13, 14, 23) ;
une couche à trous d'air (14P) qui est une couche de cristal photonique incluse dans la première couche semiconductrice (14) et qui comporte un trou d'air (14K, 14K1, 14K2) disposé avec une périodicité bidimensionnelle dans un plan parallèle à la couche active (15) ; et
une couche réfléchissante (20B) qui est prévue sur la deuxième couche semiconductrice (16, 17, 18, 19) et qui a une surface réfléchissante (SR),
dans lequel une surface d'émission de lumière est prévue sur une surface arrière (12R) du substrat (12) ;
dans lequel la couche à trous d'air (14P) fournit une surface de diffraction (WS) qui est disposée plus près de la couche active (15) que d'un centre de la couche à trous d'air (14P) selon une direction de profondeur,
dans lequel une distance de séparation (dr) entre la surface de diffraction (WS) et la surface réfléchissante (SR) est prévue de sorte qu'une intensité lumineuse de la lumière combinée de la première lumière diffractée (Ld) diffractée par la surface de diffraction (WS) vers un côté de la surface d'émission de lumière et de la deuxième lumière diffractée (Lr) diffractée par la surface de diffraction (WS) vers un côté de la couche de réflexion et réfléchie sur la surface réfléchissante (SR) soit supérieure à une intensité lumineuse de la première lumière diffractée (Ld),
dans lequel la distance de séparation (dr) est une différence de phase entre la première lumière diffractée (Ld) diffractée par la surface de diffraction (WS) et la deuxième lumière diffractée (Lr) diffractée par la surface de diffraction (WS) et réfléchie par la surface réfléchissante (SR) et, lorsque la différence de phase est définie comme étant θ (deg), qu'une longueur d'onde de la première lumière diffractée est définie comme étant λ, qu'un indice de réfraction moyen d'une couche cristalline entre la surface de diffraction (WS) et la surface réfléchissante (SR) est défini comme étant nₐᵥₑ, et qu'un nombre entier égal à 0 ou plus est défini comme étant m, la distance de séparation (dr) est représentée par l'expression suivante : $dr = \left(\frac{θ}{360 °}+0,5+m\right) \frac{λ}{2 {n}_{ave}}$ et,
lorsqu'une réflectivité de la surface réfléchissante (SR) est définie comme étant R, que des pertes de la couche à trous d'air (14P) selon une direction dans le plan et une direction verticale de la couche à trous d'air (14P) sont définies comme étant αn et αp, respectivement, et que des pertes internes sont définies comme étant αi, la différence de phase θ satisfait : $cosθ > - \frac{\sqrt{R} \left({α}_{n}+{α}_{p}+{α}_{i}\right)}{{α}_{n} + 2 \left({α}_{p}+{α}_{i}\right)} .$

2. Élément laser à émission de surface (10, 30) selon la revendication 1, dans lequel un film antireflet (27) est prévu sur la surface d'émission de lumière du substrat (12).

3. Élément laser à émission de surface (10, 30) selon la revendication 1 ou 2, dans lequel
la première couche semiconductrice (13, 14, 23), la couche active (15) et la deuxième couche semiconductrice (16, 17, 18, 19) sont des couches semiconductrices à base de nitrure du groupe 3, et la première couche semiconductrice (13, 14, 23) et la deuxième couche semiconductrice (16, 17, 18, 19) sont une couche semiconductrice de type n et une couche semiconductrice de type p, respectivement.

4. Élément laser à émission de surface (30) selon l'une quelconque des revendications 1 à 3, dans lequel
la deuxième couche semiconductrice (16, 17, 18, 19) est une couche semiconductrice de type p, et un film conducteur translucide (25) est prévu entre la surface réfléchissante (SR) et la couche semiconductrice de type p (16, 17, 18, 19).

5. Élément laser à émission de surface (30) selon la revendication 4, dans lequel
le film conducteur translucide (25) est un film d'oxyde d'indium-étain, ITO, la couche réfléchissante (SR) est un film d'argent, Ag, et la distance de séparation (dr) satisfait $\frac{\left(0,5+m\right) λ}{2 {n}_{ave}} < dr < \frac{\left(0,921+m\right) λ}{2 {n}_{ave}} ou \frac{\left(1,079+m\right) λ}{2 {n}_{ave}} < dr < \frac{\left(1,5+m\right) λ}{2 {n}_{ave}} .$

6. Élément laser à émission de surface (10, 30) selon l'une quelconque des revendications 1 à 3, dans lequel
la deuxième couche semiconductrice (16, 17, 18, 19) est une couche semiconductrice de type p, une deuxième électrode (20B) prévue sur la deuxième couche semiconductrice (16, 17, 18, 19) est en palladium, Pd, et la distance de séparation (dr) satisfait $\frac{\left(0,5+m\right) λ}{2 {n}_{ave}} < dr < \frac{\left(0,861+m\right) λ}{2 {n}_{ave}} ou \frac{\left(1,139+m\right) λ}{2 {n}_{ave}} < dr < \frac{\left(1,5+m\right) λ}{2 {n}_{ave}} .$

7. Élément laser à émission de surface (10, 30) selon l'une quelconque des revendications 1 à 6, dans lequel
la couche à trous d'air (14P) a une épaisseur (d_{PC}) inférieure à une longueur d'onde de la longueur du chemin optique de la couche à trous d'air (14P).

8. Élément laser à émission de surface (10, 30) selon l'une quelconque des revendications 1 à 7, dans lequel
la couche à trous d'air (14P) est une couche de cristal photonique ayant une structure à double réseau dans laquelle un trou d'air principal (14K1) et un trou d'air secondaire (14K2) ayant un diamètre de trou d'air et une profondeur petits par rapport au trou d'air principal (14K1) sont disposés au niveau de points du réseau, et une position du centre de gravité (CD2) du trou d'air secondaire (14K2) dans une direction de profondeur est plus proche d'un côté de la couche active (15) que de la position du centre de gravité (CD1) du trou d'air principal (14K1).
